# EUROPEAN PATENT SPECIFICATION

(11) **EP 4 159 541 B1**
(45) Date of publication and mention of the grant of the patent: **12.08.2026**
(21) Application number: 20940676.8
(22) Date of filing: 18.06.2020
(51) Int. Cl.: H03K 17/10, H03K 17/082, H03K 17/18, H03K 17/06, B60R 16/02

(54) **VEHICLE-MOUNTED DRIVING CIRCUIT, VEHICLE-MOUNTED DRIVING CHIP, VEHICLE-MOUNTED DRIVING DEVICE AND ELECTRONIC DEVICE**
FAHRZEUGMONTIERTE ANTRIEBSSCHALTUNG, FAHRZEUGMONTIERTER ANTRIEBSCHIP, FAHRZEUGMONTIERTE ANTRIEBSVORRICHTUNG UND ELEKTRONISCHE VORRICHTUNG
CIRCUIT D'ENTRAÎNEMENT MONTÉ SUR VÉHICULE, PUCE D'ENTRAÎNEMENT MONTÉE SUR VÉHICULE, DISPOSITIF D'ENTRAÎNEMENT MONTÉ SUR VÉHICULE ET DISPOSITIF ÉLECTRONIQUE

(43) Date of publication of application: 05.04.2023
(73) Proprietor: Yinwang Intelligent Technologies Co., Ltd., Shenzhen, Guangdong 518110 (CN)
(72) Inventor: LI, Hongqiang, Shenzhen, Guangdong 518129 (CN); TANG, Weidong, Shenzhen, Guangdong 518129 (CN)
(74) Representative: Maiwald GmbH
(86) International application number: PCT/CN2020/096858
(87) International publication number: WO 2021/253336

(56) References cited:
- EP-A1- 0 609 158
- EP-A1- 0 865 055
- EP-A1- 2 763 319
- CN-A- 104 837 245
- CN-A- 107 959 492
- CN-U- 201 571 234
- US-A- 6 034 449

## Description

### TECHNICAL FIELD

This application relates to the vehicle field, and in particular, to a vehicle-mounted drive circuit, a vehicle-mounted drive chip, a vehicle-mounted drive part, and an electronic device.

### BACKGROUND

EP0609158A1 describes that the fail-safe power interface receives DC logic signals as input. It is described that these signals are coded dynamically by an oscillator and transmitted by a programmable logic circuit with two power transistors connected in series. It is described that the power interface carries out an on-line self-test, using narrow pulses. It is described that the programmable logic circuit supplies an oscillating diagnostic signal in the absence of a breakdown and a DC signal as soon as a fault is detected.

A load in a vehicle needs to be driven by using a drive circuit. The load may include a motor, a dashboard, a speaker, a sensor, an electronic control unit (electronic control unit, ECU), a valve body, or the like.

A drive circuit of the load usually includes a pre-drive circuit and a drive transistor (also referred to as a power transistor). The pre-drive circuit is connected to the drive transistor, and the drive transistor is further connected to each of a power supply and the load. The pre-drive circuit is configured to provide a switching signal for the drive transistor, to control the drive transistor to be conducted or cut off. When the drive transistor is conducted, a drive current may be provided for the load, to drive the load to operate; and when the drive transistor is cut off, the load stops operating.

However, when the drive transistor is faulty, for example, is short-circuited, the pre-drive circuit may not be able to control a conducted/cutoff state of the drive transistor, resulting in a risk that a device in the drive circuit and the load are damaged.

### SUMMARY

This application provides a vehicle-mounted drive circuit, a vehicle-mounted drive chip, a vehicle-mounted drive part, and an electronic device, to reduce a risk that an element in the drive circuit and a load are damaged when a drive transistor is faulty.

Appended claim 1 defines a vehicle-mounted drive circuit. Appended claim 12 defines a vehicle-mounted drive part.

### Specifically:

### Claim 1 defines:

A vehicle-mounted drive circuit, wherein the vehicle-mounted drive circuit comprises a drive chip, a first drive transistor, and a first switching transistor, and the drive chip comprises a pre-drive circuit and a shut off circuit;
the first drive transistor and the first switching transistor are connected in series, and the first drive transistor and the first switching transistor are configured to be connected in series between a power supply and a first load;
the pre-drive circuit is connected to a gate electrode of the first drive transistor, and the pre-drive circuit controls, in response to a first power-on instruction, the first drive transistor to be conducted, and controls, in response to a first power-off instruction, the first drive transistor to be cut off; and
the shut off circuit is connected to a gate electrode of the first switching transistor, and the shut off circuit controls, in response to the first power-on instruction, the first switching transistor to be conducted, and controls, in response to the first power-off instruction or a first fault signal, the first switching transistor to be cut off;
the pre-drive circuit is configured to control, in response to the first fault signal, the first drive transistor to be cut off; and wherein when both the first drive transistor and the first switching transistor are controlled to be conducted, a first current channel between the power supply and the first load is conducted, and the power supply can provide a drive current for the first load by using the first drive transistor and the first switching transistor, and when either of the first drive transistor and the first switching transistor is cut off, the first current channel between the power supply and the first load is cut off, and the power supply cannot provide the drive current for the first load.

### Claim 12 defines;

A vehicle-mounted drive part, wherein the vehicle-mounted drive part comprises a main control circuit and a drive circuit, and the drive circuit is the vehicle-mounted drive circuit as described above; and
the main control circuit is connected to the drive circuit, and is configured to send a first power-on instruction to the drive circuit in response to a power-on request for a first load, and send a first power-off instruction to the drive circuit in response to a power-off request for the first load.
The invention and its scope of protection is defined by these claims. The following aspects and implementations of the disclosure provide examples of combinations of technical subject matters.

According to one aspect, this application provides a vehicle-mounted drive circuit. The vehicle-mounted drive circuit includes a drive chip, a first drive transistor, and a first switching transistor, and the drive chip includes a pre-drive circuit and a shut off circuit; the first drive transistor and the first switching transistor are connected in series, and the first drive transistor and the first switching transistor are connected in series between a power supply and a first load; the pre-drive circuit is connected to a gate electrode of the first drive transistor, and the pre-drive circuit controls, in response to a first power-on instruction, the first drive transistor to be conducted, and controls, in response to a first power-off instruction, the first drive transistor to be cut off; and the shut off circuit is connected to a gate electrode of the first switching transistor, and the shut off circuit controls, in response to the first power-on instruction, the first switching transistor to be conducted, and controls, in response to the first power-off instruction or a first fault signal, the first switching transistor to be cut off.

Because the shut off circuit in the drive chip can cut off the first switching transistor in response to the first fault signal, it may be ensured that a current channel between the power supply and the first load is cut off in a timely manner in a fault scenario, to avoid a case in which each element in the vehicle-mounted drive circuit and the first load are damaged when continuously operating in the fault scenario. In addition, both the pre-drive circuit for controlling the current channel to be conducted or cut off and the shut off circuit for providing a redundant shut off path for the current channel are integrated into the drive chip, to avoid increasing a volume and costs of the drive circuit, and improve a degree of integration of the vehicle-mounted drive circuit.

Optionally, the shut off circuit includes an interface sub-circuit and an execution sub-circuit, and the execution sub-circuit is connected to each of the interface sub-circuit and the gate electrode of the first switching transistor; the interface sub-circuit provides a first switching signal for the execution sub-circuit in response to the first power-on instruction, and provides a second switching signal for the execution sub-circuit in response to the first power-off instruction or the first fault signal; and the execution sub-circuit controls, in response to the first switching signal, the first switching transistor to be conducted, and controls, in response to the second switching signal, the first switching transistor to be cut off.

The execution sub-circuit may be a push-pull circuit. The push-pull circuit is used to control a conducted/cutoff state of the first switching transistor, to ensure that a conduction current required by the first switching transistor can be provided, and ensure a switching rate of the first switching transistor.

Optionally, the first switching transistor is an N-type transistor, and the shut off circuit further includes a first charge pump (charge pump); the first charge pump is connected to each of a power supply terminal and the execution sub-circuit, and the first charge pump is configured to: increase a voltage from the power supply terminal and provide the voltage for the execution sub-circuit; and the execution sub-circuit is configured to control, under driving of the first charge pump and in response to the first switching signal, the first switching transistor to be conducted.

The voltage from the power supply terminal is increased by using the first charge pump, to ensure that the execution sub-circuit can effectively conduct the first switching transistor.

Optionally, the first fault signal includes a first fault sub-signal, and the drive chip further includes a fault detection circuit connected to the shut off circuit; and the fault detection circuit is configured to detect whether the vehicle-mounted drive circuit is faulty, and the fault detection circuit sends the first fault sub-signal to the shut off circuit if the fault detection circuit detects that the vehicle-mounted drive circuit is faulty.

The fault detection circuit integrated into the drive chip detects a fault, to ensure that the first fault sub-signal can be sent to the shut off circuit in a timely manner when the fault is detected, to indicate the shut off circuit to cut off the first switching transistor in a timely manner.

Optionally, the drive chip further includes one or more of a peripheral interface, a first current detection circuit, a watchdog circuit, and a temperature sensor; the peripheral interface is connected to a main control circuit, and the peripheral interface is configured to: communicate with the main control circuit, and send a first interrupt instruction to the fault detection circuit if detecting that communication with the main control circuit is interrupted; the watchdog circuit is connected to each of the peripheral interface and the fault detection circuit, and the watchdog circuit is configured to send a second interrupt instruction to the fault detection circuit if detecting that communication with the peripheral interface is interrupted; the first current detection circuit is connected to the fault detection circuit, and the first current detection circuit is configured to: detect a current in a first current channel between the power supply and the first load, and send, to the fault detection circuit, a first voltage for indicating a magnitude of the current in the first current channel; the temperature sensor is configured to: detect a junction temperature of the drive chip, and send the junction temperature to the fault detection circuit; and
it is determined that the vehicle-mounted drive circuit is faulty, if the fault detection circuit detects any of the following cases: the first interrupt instruction is received; the second interrupt instruction is received; it is determined, based on the first voltage, that the first current channel is short-circuited or open-circuited; and the junction temperature is greater than a temperature threshold.

In a solution provided in this application, because the fault detection circuit can detect a plurality of faults of different types, fault detection reliability is high.

Optionally, the drive chip includes the first current detection circuit, and the vehicle-mounted drive circuit further includes a first sampling resistor; the first sampling resistor is connected to the first drive transistor and the first switching transistor in series; and two input terminals of the first current detection circuit are bridged over two terminals of the first sampling resistor, a first output terminal of the first current detection circuit is connected to the fault detection circuit, and the first current detection circuit is configured to: collect a first voltage between the two terminals of the first sampling resistor, and send the collected first voltage to the fault detection circuit.

The first voltage collected by the first current detection circuit may accurately reflect the magnitude of the current in the first current channel, so that the fault detection circuit can accurately determine whether the first current channel is short-circuited or open-circuited.

Optionally, a second output terminal of the first current detection circuit is connected to the peripheral interface; and the first current detection circuit is further configured to: perform analog-to-digital conversion on the collected voltage, to obtain a digital parameter of the voltage, and send the digital parameter to the main control circuit through the peripheral interface.

The first current detection circuit sends the digital parameter of the collected voltage to the main control circuit, so that the main control circuit can also accurately determine, based on the voltage, whether the first current channel is short-circuited or open-circuited.

Optionally, the first current detection circuit includes a first filter, a second filter, a differential amplifier (differential amplifier), and an analog-to-digital converter (analog-to-digital converter, ADC); an input terminal of the first filter is connected to one terminal of the first sampling resistor, and an output terminal of the first filter is connected to a first input terminal of the differential amplifier; an input terminal of the second filter is connected to the other terminal of the first sampling resistor, and an output terminal of the second filter is connected to a second input terminal of the differential amplifier; and an output terminal of the differential amplifier is connected to each of the fault detection circuit and an input terminal of the analog-to-digital converter, and an output terminal of the analog-to-digital converter is connected to the peripheral interface.

The two filters may be configured to filter out a high-frequency glitch on the voltage between the two terminals of the first sampling resistor, and the differential amplifier can amplify the collected voltage and provide the amplified voltage to each of the fault detection circuit and the analog-to-digital converter, so that a next circuit can accurately determine, based on the amplified voltage, whether the first current channel is short-circuited or open-circuited.

Optionally, a control terminal of the differential amplifier is further connected to the peripheral interface; and the peripheral interface is further configured to configure a gain of the differential amplifier in response to a gain configuration instruction sent by the main control circuit.

Because the main control circuit may flexibly configure the gain of the differential amplifier, current collection flexibility and accuracy are effectively improved.

Optionally, the vehicle-mounted drive circuit further includes a second drive transistor, a second switching transistor, a second current detection circuit, and a second sampling resistor; the second drive transistor, the second switching transistor, and the second sampling resistor are connected in series, and the second drive transistor, the second switching transistor, and the second sampling resistor are connected in series between the power supply and a second load; the pre-drive circuit is further connected to a gate electrode of the second drive transistor, and the pre-drive circuit is further configured to: control, in response to a second power-on instruction, the second drive transistor to be conducted, and control, in response to a second power-off instruction, the second drive transistor to be cut off; the shut off circuit is further connected to the gate electrode of the second switching transistor, and the shut off circuit is further configured to: control, in response to the second power-on instruction, the second switching transistor to be conducted, and control, in response to the second power-off instruction or a second fault signal, the second switching transistor to be cut off; two input terminals of the second current detection circuit are bridged over two terminals of the second sampling resistor, a first output terminal of the second current detection circuit is connected to the fault detection circuit, the second current detection circuit is configured to: collect a second voltage between the two terminals of the second sampling resistor, and send the collected second voltage to the fault detection circuit, and the second voltage indicates a magnitude of a current in a second current channel between the power supply and the second load; and
the second fault signal is sent to the shut off circuit if the fault detection circuit detects any of the following cases: the first interrupt instruction is received; the second interrupt instruction is received; it is determined, based on the second voltage, that the second current channel is short-circuited or open-circuited; and the junction temperature is greater than the temperature threshold.

Compared with a case in which a discrete device is used to separately control a conducted/cutoff state of each current channel, in a case in which the drive chip in the vehicle-mounted drive circuit provided in this embodiment of this application may control a conducted/cutoff state of at least two current channels, a degree of integration of the vehicle-mounted drive circuit is effectively improved, and a volume of the vehicle-mounted drive circuit is reduced. In addition, one current detection circuit is configured for each current channel, to independently detect a current in each current channel, and further independently control each current channel.

Optionally, the first fault signal includes a second fault sub-signal, and the shut off circuit is further connected to the main control circuit through the peripheral interface of the drive chip; and the peripheral interface is configured to: receive the second fault sub-signal sent by the main control circuit, and send, to the shut off circuit for sending, the second fault sub-signal sent by the main control circuit.

The shut off circuit may further control, in response to the second fault sub-signal sent by the main control circuit, the first switching transistor to be cut off. Therefore, reliability of cutting off the first switching transistor in the fault scenario is effectively improved.

Optionally, the drive chip further includes a second charge pump; and the second charge pump is connected to the pre-drive circuit, and is configured to provide a drive voltage for the pre-drive circuit.

Because the switching transistor and the drive transistor may be respectively driven by using two independent charge pumps, a case in which a supply fault is caused when a charge pump is shared can be avoided, to ensure drive reliability.

Optionally, the drive chip is further configured to control, in response to the first fault signal, the first drive transistor to be cut off. Therefore, it can be ensured that when one of the first drive transistor and the first switching transistor fails, the first current channel between the power supply and the first load may be cut off by cutting off another transistor, to ensure fault protection reliability.

According to another aspect, a vehicle-mounted drive chip is provided. The vehicle-mounted drive chip includes a first drive transistor, a first switching transistor, a pre-drive circuit, and a shut off circuit; the first drive transistor and the first switching transistor are connected in series, and the first drive transistor and the first switching transistor are connected in series between a power supply and a first load; the pre-drive circuit is connected to a gate electrode of the first drive transistor, and the pre-drive circuit controls, in response to a first power-on instruction, the first drive transistor to be conducted, and controls, in response to a first power-off instruction, the first drive transistor to be cut off; and the shut off circuit is connected to a gate electrode of the first switching transistor, and the shut off circuit controls, in response to the first power-on instruction, the first switching transistor to be conducted, and controls, in response to the first power-off instruction or a first fault signal, the first switching transistor to be cut off.

Because the shut off circuit in the drive chip can cut off the first switching transistor in response to the first fault signal, it may be ensured that a current channel between the power supply and the first load is cut off in a timely manner in a fault scenario, to avoid a case in which each element in the vehicle-mounted drive circuit and the first load are damaged when continuously operating in the fault scenario. In addition, the pre-drive circuit, the shut off circuit, the drive transistor, and the switching transistor are all integrated into the drive chip, to effectively improve a degree of integration of the drive circuit.

According to still another aspect, a vehicle-mounted drive part is provided. The vehicle-mounted drive part includes a main control circuit and a drive circuit, and the drive circuit is the vehicle-mounted drive circuit or the vehicle-mounted drive chip provided in the foregoing aspects; the main control circuit is connected to the drive circuit, and is configured to: send a first power-on instruction to each of a pre-drive circuit and a shut off circuit in the drive circuit in response to a power-on request for a first load, and send a first power-off instruction to each of the pre-drive circuit and the shut off circuit in response to a power-off request for the first load.

Optionally, the main control circuit is further configured to: detect whether the vehicle-mounted drive part is faulty, and send a second fault sub-signal to the drive circuit if detecting that the vehicle-mounted drive part is faulty.

According to yet another aspect, an electronic device is provided. The electronic device includes a power supply, a first load, and the vehicle-mounted drive part provided in the foregoing aspects; and a first drive transistor and a first switching transistor in the vehicle-mounted drive part are connected in series between the power supply and the first load.

A technical solution provided in this application includes at least the following beneficial effects:

This application provides a vehicle-mounted drive circuit, a vehicle-mounted drive chip, a vehicle-mounted drive part, and an electronic device. The vehicle-mounted drive circuit includes a drive chip, and a first drive transistor and a first switching transistor that are connected in series between a power supply and a first load, and the drive chip includes a pre-drive circuit and a shut off circuit. Because the shut off circuit can cut off the first switching transistor in response to the first fault signal, it may be ensured that a current channel between the power supply and the first load is cut off in a timely manner in the fault scenario, to avoid a case in which each element in the vehicle-mounted drive circuit and the first load are damaged when continuously operating in the fault scenario. In addition, both the shut off circuit and the pre-drive circuit are integrated into the drive chip, to avoid increasing a volume and costs of the vehicle-mounted drive circuit, and improve a degree of integration of the vehicle-mounted drive circuit.

### BRIEF DESCRIPTION OF DRAWINGS

FIG. 1 is a schematic diagram of a structure of a vehicle-mounted drive circuit according to an embodiment of this application;
FIG. 2 is a schematic diagram of a structure of a shut off circuit according to an embodiment of this application;
FIG. 3 is a schematic diagram of a structure of another vehicle-mounted drive circuit according to an embodiment of this application;
FIG. 4 is a schematic diagram of a partial structure of a vehicle-mounted drive circuit according to an embodiment of this application;
FIG. 5 is a schematic diagram of a structure of still another vehicle-mounted drive circuit according to an embodiment of this application;
FIG. 6 is a schematic diagram of a structure of a vehicle-mounted drive chip according to an embodiment of this application;
FIG. 7 is a schematic diagram of a structure of a vehicle-mounted drive part according to an embodiment of this application;
FIG. 8 is a schematic diagram of a structure of an electronic device according to an embodiment of this application;
FIG. 9 is a schematic diagram of a structure of a power supply system of a vehicle according to an embodiment of this application; and
FIG. 10 is a schematic diagram of a partial structure of a power supply system of a vehicle according to an embodiment of this application.

### DESCRIPTION OF EMBODIMENTS

To make objectives, technical solutions, and advantages of this application clearer, the following further describes implementations of this application in detail with reference to the accompanying drawings.

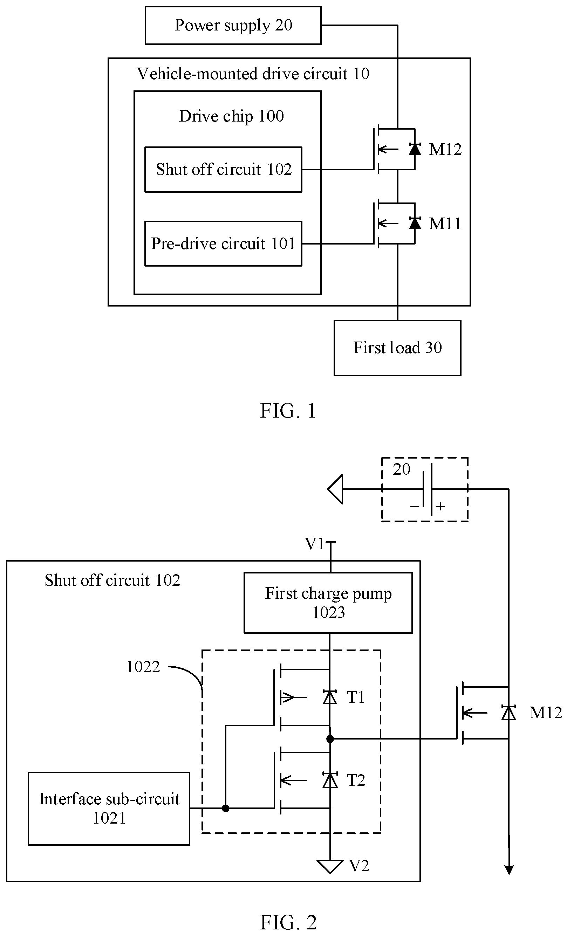

FIG. 1 is a schematic diagram of a structure of a vehicle-mounted drive circuit according to an embodiment of this application. As shown in FIG. 1, a vehicle-mounted drive 10 circuit includes a drive chip 100, a first drive transistor M11, and a first switching transistor M12. The drive chip 100 includes a pre-drive circuit 101 and a shut off circuit 102.

The first drive transistor M11 and the first switching transistor M12 are connected in series, and the first drive transistor M11 and the first switching transistor M12 are connected in series between a power supply 20 and a first load 30.

For example, referring to FIG. 1, a drain electrode of the first switching transistor M12 is connected to the power supply 20, a source electrode of the first switching transistor M12 is connected to a drain electrode of the first drive transistor M11, and a source electrode of the first drive transistor M11 is connected to the first load 30. Certainly, a position of the first drive transistor M11 and a position of the first switching transistor M12 may be exchanged. In other words, the drain electrode of the first drive transistor M11 is connected to the power supply 20, and the source electrode of the first switching transistor M12 is connected to the first load 30. The first drive transistor M11 may also be referred to as a main power transistor.

The pre-drive circuit 101 is connected to a gate electrode of the first drive transistor M11, and the pre-drive circuit 101 controls, in response to a first power-on instruction, the first drive transistor M11 to be conducted, and controls, in response to a first power-off instruction, the first drive transistor M11 to be cut off.

The shut off circuit 102 is connected to a gate electrode of the first switching transistor M12, and the shut off circuit 102 controls, in response to the first power-on instruction, the first switching transistor M12 to be conducted, and controls, in response to the first power-off instruction or a first fault signal, the first switching transistor M12 to be cut off.

When both the first drive transistor M11 and the first switching transistor M12 are conducted, a first current channel between the power supply 20 and the first load 30 is conducted, and the power supply 20 can provide a drive current for the first load 30 by using the first drive transistor M11 and the first switching transistor M12, to drive the first load 30 to operate. When either of the first drive transistor M11 and the first switching transistor M12 is cut off, the first current channel between the power supply 20 and the first load 30 is cut off, the power supply 20 cannot provide the drive current for the first load 30, and the first load 30 stops operating.

In this embodiment of this application, both the first power-on instruction and the first power-off instruction may be sent by a main control circuit. For example, after detecting a power-on request for the first load 30, the main control circuit may send the first power-on instruction to each of the pre-drive circuit 101 and the shut off circuit 102, to conduct the first drive transistor M11 and the first switching transistor M12. After detecting a power-off request for the first load 30, the main control circuit may further send the first power-off instruction to each of the pre-drive circuit 101 and the shut off circuit 102, to cut off the first drive transistor M11 and the first switching transistor M12.

The first fault signal may be sent after the main control circuit detects a fault, or may be generated after a fault detection circuit inside the drive chip 100 detects a fault. After detecting a fault, the main control circuit or the fault detection circuit sends the first fault signal to the shut off circuit 102, to indicate the shut off circuit 102 to cut off the first switching transistor M12, so that it can be ensured that the first current channel between the power supply 20 and the first load 30 is cut off in a timely manner, to effectively avoid spreading the fault and a disaster. Because the shut off circuit 102 can cut off the first switching transistor M12 in a timely manner in a fault scenario, the shut off circuit 102 may also be referred to as an emergency shut off (emergency shut off) circuit.

Optionally, the main control circuit or the fault detection circuit may send the first fault signal to the pre-drive circuit 101 after detecting the fault. The pre-drive circuit 101 may cut off the first drive transistor M11 in response to the first fault signal. Therefore, it can be ensured that when one of the first drive transistor M11 and the first switching transistor M12 fails, the first current channel between the power supply 20 and the first load 30 may be cut off by cutting off another transistor, to ensure fault protection reliability.

In conclusion, this embodiment of this application provides a vehicle-mounted drive circuit. The vehicle-mounted drive circuit includes the drive chip, and the first drive transistor and the first switching transistor that are connected in series between the power supply and the first load. Because the shut off circuit in the drive chip can cut off the first switching transistor in response to the first fault signal, it may be ensured that the current channel between the power supply and the first load is cut off in a timely manner in the fault scenario, to avoid a case in which each element in the vehicle-mounted drive circuit and the first load are damaged when continuously operating in the fault scenario. Because the shut off circuit provides a redundant shut off path for the first current channel, reliability of the vehicle-mounted drive circuit during operation is effectively improved.

In addition, both the pre-drive circuit for controlling the current channel to be conducted or cut off and the shut off circuit for providing the redundant shut off path for the current channel are integrated into the drive chip, to avoid increasing a volume and costs of the vehicle-mounted drive circuit, and improve a degree of integration of the vehicle-mounted drive circuit. Further, because both the first drive transistor and the first switching transistor are disposed independently of the drive chip and are not integrated into the drive chip, a problem that the drive chip is overheated due to a large drive current does not need to be considered. In other words, the first drive transistor and the first switching transistor may provide a large drive current for the first load.

FIG. 2 is a schematic diagram of a structure of a shut off circuit according to an embodiment of this application. As shown in FIG. 2, the vehicle-mounted drive circuit 10 further includes a power supply terminal V1 and a ground terminal V2. The power supply terminal V1 is connected to the power supply 20, and is configured to provide a drive voltage. For example, the drive voltage may be 12 volts (V) or 24 V

As shown in FIG. 2, the shut off circuit 102 includes an interface sub-circuit 1021 and an execution sub-circuit 1022, and the execution sub-circuit 1022 is connected to each of the interface sub-circuit 1021, a gate electrode of the first switching transistor M12, the power supply terminal V1, and the ground terminal V2.

The interface sub-circuit 1021 provides a first switching signal for the execution sub-circuit 1022 in response to the first power-on instruction, and provides a second switching signal for the execution sub-circuit 1022 in response to a cutoff instruction or the first fault signal. In other words, the interface sub-circuit 1021 may be configured to: receive an instruction, process the received instruction, and provide a switching signal for the execution sub-circuit 1022. The interface sub-circuit 1021 may include a transistor and a resistor.

The execution sub-circuit 1022 controls, in response to the first switching signal and under driving of the power supply terminal V1, the first switching transistor M12 to be conducted, and controls, in response to the second switching signal, the first switching transistor M12 to be cut off.

The execution sub-circuit 1022 may be a push-pull (push pull) circuit. As shown in FIG. 2, the push-pull circuit includes two transistors T1 and T2 that are symmetrically disposed and have different polarities. For example, the transistor T1 is a P-type transistor, and the transistor T2 is an N-type transistor. Gate electrodes of the two transistors T1 and T2 are both connected to the interface sub-circuit 1021, a source electrode of the transistor T1 is connected to the power supply terminal V1, a drain electrode is connected to the gate electrode of the first switching transistor M12, a source electrode of the transistor T2 is connected to the ground terminal V2, and a drain electrode is connected to the gate electrode of the first switching transistor M12. Alternatively, the execution sub-circuit 1022 may be an open drain (open drain, OD) circuit.

When the interface sub-circuit 1021 provides the first switching signal, the transistor T1 is conducted, the transistor T2 is cut off, and a voltage of the power supply terminal V1 is loaded onto the gate electrode of the first switching transistor M12, so that the first switching transistor M12 is conducted. When the interface sub-circuit 1021 provides the second switching signal, the transistor T2 is conducted, the transistor T1 is cut off, and a voltage of the ground terminal V2 is loaded onto the gate electrode of the first switching transistor M12, so that the first switching transistor M12 is cut off.

The push-pull circuit is used to control a conducted/cutoff state of the first switching transistor M12, to ensure that a conduction current required by the first switching transistor M12 can be provided, and ensure a switching rate of the first switching transistor M12.

In this embodiment of this application, the first switching transistor M12 may be an N-type transistor. Correspondingly, as shown in FIG. 2, the shut off circuit 102 further includes a first charge pump 1023.

The first charge pump 1023 is connected to each of the power supply terminal V1 and the execution sub-circuit 1022, and the first charge pump 1023 is configured to: increase the drive voltage provided by the power supply terminal V1 and provide the increased drive voltage for the execution sub-circuit 1022. Correspondingly, the execution sub-circuit 1022 may control, in response to the first switching signal and under driving of the first charge pump 1023, the first switching transistor M12 to be conducted.

Because the N-type transistor is conducted when a gate-source voltage difference (namely, a voltage difference between a gate electrode voltage and a source electrode voltage) is greater than a threshold voltage, and the threshold voltage of the N-type transistor is greater than 0 (an order of magnitude of the threshold voltage is usually V, for example, the threshold voltage may be 2 V or 3 V), the first charge pump 1023 needs to provide a high voltage for the gate electrode of the first switching transistor M12, to ensure that the first switching transistor M12 can be normally conducted.

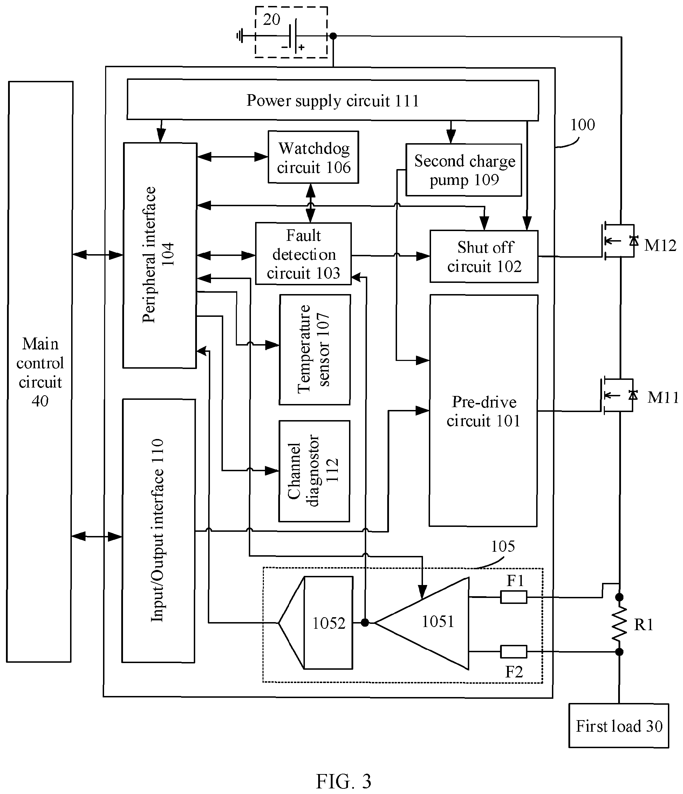

Optionally, the first fault signal received by the shut off circuit 102 may include a first fault sub-signal. As shown in FIG. 3, the drive chip 100 further includes a fault detection circuit 103 connected to the shut off circuit 102.

The fault detection circuit 103 is configured to detect whether the vehicle-mounted drive circuit 10 is faulty. The fault detection circuit 103 sends the first fault sub-signal to the shut off circuit 102 if the fault detection circuit 103 detects that the vehicle-mounted drive circuit is faulty.

Because the fault detection circuit 103 is integrated into the drive chip 100, the fault detection circuit 103 may also be referred to as a build in self test (build in self test, BIST) circuit. The fault detection circuit 103 integrated into the drive chip 100 detects a fault, to ensure that the first fault sub-signal can be sent to the shut off circuit 102 in a timely manner when the fault is detected, to indicate the shut off circuit 102 to cut off the first switching transistor M12 in a timely manner, so as to avoid a physical damage caused when the drive chip 100 and an external transistor are in an abnormal operating state for a long time period. For example, after detecting the fault, the fault detection circuit 103 may control the shut off circuit 102 to cut off the first switching transistor M12 within 1 ms.

In this embodiment of this application, as shown in FIG. 3, the drive chip 100 may further include one or more of a peripheral interface 104, a first current detection circuit 105, a watchdog (watchdog) circuit 106, and a temperature sensor 107. For example, the drive chip 100 shown in FIG. 3 includes the peripheral interface 104, the first current detection circuit 105, the watchdog circuit 106, and the temperature sensor 107.

The peripheral interface 104 is connected to a main control circuit 40, and the peripheral interface 104 is configured to: communicate with the main control circuit 40, and send a first interrupt instruction to the fault detection circuit 103 if detecting that communication with the main control circuit 40 is interrupted. Optionally, the peripheral interface 104 may be a serial peripheral interface (serial peripheral interface, SPI).

The watchdog circuit 106 is connected to each of the peripheral interface 104 and the fault detection circuit 103, and the watchdog circuit 106 is configured to send a second interrupt instruction to the fault detection circuit 103 if detecting that communication with the peripheral interface 104 is interrupted (in other words, handshake communication is abnormal).

The first current detection circuit 105 is connected to the fault detection circuit 103. The first current detection circuit 105 is configured to: detect a current in the first current channel between the power supply 20 and the first load 30, and send, to the fault detection circuit 103, a first voltage for indicating a magnitude of the current.

The temperature sensor 107 is configured to: detect a junction temperature of the drive chip 100, and send the junction temperature to the fault detection circuit 103. The junction temperature is a temperature of a PN junction inside the drive chip 100, that is, a maximum temperature inside the drive chip.

It is determined that the vehicle-mounted drive circuit 10 is faulty, if the fault detection circuit 103 detects any of the following cases:
1. The first interrupt instruction is received.
2. The second interrupt instruction is received.
3. That the first current channel is short-circuited or open-circuited is determined based on the first voltage.
4. The junction temperature is greater than a temperature threshold.

For Case 3, the fault detection circuit 103 prestores a first voltage threshold, a second voltage threshold, and a third voltage threshold, the first voltage threshold is greater than the third voltage threshold, and the third voltage threshold is greater than the second voltage threshold. If the fault detection circuit 103 detects, when the first current channel is conducted (in other words, after the first power-on instruction is received), that the first voltage sent by the first current detection circuit 105 is greater than the first voltage threshold, the fault detection circuit 103 may determine that the current in the first current channel is an overcurrent, and further, may determine that the first current channel is short-circuited to the ground. If the fault detection circuit 103 detects, when the first current channel is cut off (in other words, after the first power-off instruction is received), that the first voltage sent by the first current detection circuit 105 is greater than the second voltage threshold, the fault detection circuit 103 may determine that the first current channel is short-circuited to the power supply. If the fault detection circuit 103 detects, when the first current channel is conducted, that the first voltage sent by the first current detection circuit 105 is less than the third voltage threshold, the fault detection circuit 103 may determine that the first current channel is open-circuited. A magnitude of a current indicated by the first voltage threshold is an upper limit value that is of the current in the first current channel and that exists when the vehicle-mounted drive circuit 10 operates normally and the first current channel between the power supply 20 and the first load 30 is conducted. A magnitude of a current indicated by the second voltage threshold is an upper limit value that is of the current in the first current channel and that exists when the vehicle-mounted drive circuit 10 operates normally and the first current channel between the power supply 20 and the first load 30 is cut off. A magnitude of a current indicated by the third voltage threshold is a lower limit value that is of the current in the first current channel and that exists when the vehicle-mounted drive circuit 10 operates normally and the first current channel between the power supply 20 and the first load 30 is conducted.

Alternatively, the first current detection circuit 105 may directly collect and send a current value of the first current channel. Correspondingly, the fault detection circuit 103 prestores a first current threshold, a second current threshold, and a third current threshold, the first current threshold is greater than the third current threshold, and the third current threshold is greater than the second current threshold. If the fault detection circuit 103 detects, when the first current channel is conducted, that the current value sent by the first current detection circuit 105 is greater than the first current threshold, the fault detection circuit 103 may determine that the first current channel is short-circuited to the ground. If the fault detection circuit 103 detects, when the first current channel is cut off, that the current value sent by the first current detection circuit 105 is greater than the second voltage threshold, the fault detection circuit 103 may determine that the first current channel is short-circuited to the power supply. If the fault detection circuit 103 detects, when the first current channel is conducted, that the current value sent by the first current detection circuit 105 is less than the third current threshold, the fault detection circuit 103 may determine that the first current channel is open-circuited. The first current threshold is an upper limit value that is of the current in the first current channel and that exists when the vehicle-mounted drive circuit 10 operates normally and the first current channel between the power supply 20 and the first load 30 is conducted. The second current threshold is an upper limit value that is of the current in the first current channel and that exists when the vehicle-mounted drive circuit 10 operates normally and the first current channel between the power supply 20 and the first load 30 is cut off. The third current threshold is a lower limit value that is of the current in the first current channel and that exists when the vehicle-mounted drive circuit 10 operates normally and the first current channel between the power supply 20 and the first load 30 is conducted.

For Case 4, the fault detection circuit 103 prestores the temperature threshold, and the temperature threshold is an upper limit value that is of the junction temperature and that exists when the drive chip 100 operates normally. If the fault detection circuit 103 detects that the junction temperature sent by the temperature sensor 107 is greater than the temperature threshold, the fault detection circuit 103 may determine that the drive chip 100 is overheated, and further, may determine that the vehicle-mounted drive circuit 10 is faulty.

It can be learned the foregoing analysis that, in this embodiment of this application, the fault detection circuit 103 can detect a plurality of faults of different types, fault detection reliability is high, and reliability of the vehicle-mounted drive circuit during operation is also high.

Optionally, as shown in FIG. 3, the drive chip 100 includes the first current detection circuit 105, and the vehicle-mounted drive circuit 10 further includes a first sampling resistor R1.

The first sampling resistor R1 is connected to the first drive transistor M11 and the first switching transistor M12 in series. For example, referring to FIG. 3, one terminal of the first sampling resistor R1 is connected to the source electrode of the first drive transistor M11, and the other terminal is connected to the first load 30. Certainly, the first sampling resistor R1 may alternatively be connected in series between the first drive transistor M11 and the first switching transistor M12, or connected in series between the power supply 20 and the first switching transistor M12.

Two input terminals of the first current detection circuit 105 are bridged over two terminals of the first sampling resistor R1, a first output terminal of the first current detection circuit 105 is connected to the fault detection circuit 103, and the first current detection circuit 105 is configured to: collect a first voltage between the two terminals of the first sampling resistor R1, and send the collected first voltage to the fault detection circuit 103.

Because the voltage collected by the first current detection circuit 105 may accurately reflect the magnitude of the current in the first current channel, the fault detection circuit 103 may accurately determine, based on a magnitude of the voltage, whether the first current channel between the power supply 20 and the first load 30 is short-circuited or open-circuited.

Optionally, referring to FIG. 3, it may be further learned that a second output terminal of the first current detection circuit 105 is further connected to the peripheral interface 104. The first current detection circuit 105 is further configured to: perform analog-to-digital conversion on the collected voltage, to obtain a digital parameter of the voltage, and send the digital parameter to the main control circuit 40 through the peripheral interface 104.

The main control circuit 40 may further determine, based on the magnitude of the voltage, whether the first current channel between the power supply 20 and the first load 30 is short-circuited or open-circuited. Further, the main control circuit 40 may send a fault signal (for example, a second fault sub-signal) to the shut off circuit 102 when detecting that the first current channel is short-circuited or open-circuited, to ensure reliability of cutting off the first current channel.

As shown in FIG. 3, the first current detection circuit 105 may include a first filter F1, a second filter F2, a differential amplifier 1051, and an analog-to-digital converter 1052.

An input terminal of the first filter F1 is connected to one terminal of the first sampling resistor R1, and an output terminal of the first filter F1 is connected to a first input terminal of the differential amplifier 1051.

An input terminal of the second filter F2 is connected to the other terminal of the first sampling resistor R1, and an output terminal of the second filter F2 is connected to a second input terminal of the differential amplifier 1051.

An output terminal of the differential amplifier 1051 is connected to each of the fault detection circuit 103 and an input terminal of the analog-to-digital converter 1052, and an output terminal of the analog-to-digital converter 1052 is connected to the peripheral interface 104.

The first filter F1 and the second filter F2 each may be an electromagnetic interference (electromagnetic interference, EMI) filter. The EMI filter can filter out a high-frequency glitch on the voltage between the two terminals of the first sampling resistor R1, and can protect a voltage loaded at an input terminal of a next differential amplifier 1051 from being greater than a rated voltage (for example, 40 V or 45 V), to ensure that the differential amplifier 1051 operates normally.

The differential amplifier 1051 is configured to: amplify the collected voltage, and provide the amplified voltage to each of the fault detection circuit 103 and the analog-to-digital converter 1052, so that a next circuit can accurately determine, based on the amplified voltage, whether the first current channel is short-circuited or open-circuited. The analog-to-digital converter 1052 is configured to: perform analog-to-digital conversion on the amplified voltage, to obtain a digital parameter of the voltage, and send the digital parameter to the main control circuit 40 through the peripheral interface 104. The main control circuit 40 may determine, based on the digital parameter, whether the first current channel is short-circuited or open-circuited.

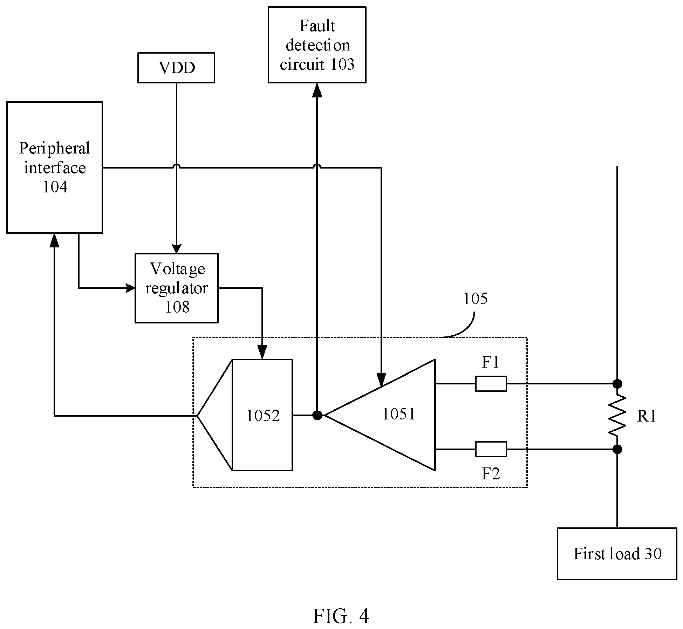

FIG. 4 is a schematic diagram of a partial structure of a vehicle-mounted drive circuit according to an embodiment of this application. As shown in FIG. 4, a control terminal of this differential amplifier 1051 is further connected to the peripheral interface 104. The peripheral interface 104 is further configured to configure a gain of the differential amplifier 1051 in response to a gain configuration instruction sent by the main control circuit 40.

Optionally, the gain configuration instruction sent by the main control circuit 40 may carry an initial gain represented by using an 8-bit (bit) binary number. The peripheral interface 104 may multiply the initial gain by a prestored target multiple, to obtain a target gain, and further, the gain of the differential amplifier 1051 may be set to the target gain. For example, the target multiple may be 10, and an upper limit value of the target gain may be 2⁸ x 10 = 2550.

In this embodiment of this application, a developer may determine the target gain of the differential amplifier 1051 based on a range that is of the current in the first current channel and that exists when the first load 30 normally operates and a resistance value of the first sampling resistor R1. In addition, the developer may configure the main control circuit 40 based on the determined target gain, so that the main control circuit 40 can configure the gain of the differential amplifier 1051 through the peripheral interface 104 of the drive chip 100 when the vehicle-mounted drive circuit 10 is initialized. Because the main control circuit can flexibly configure the gain of the differential amplifier 1051 based on the range of the current in the first current channel and the resistance value of the first sampling resistor R1, current collection flexibility and accuracy are effectively improved.

Optionally, as shown in FIG. 4, the driver chip 100 further includes a regulator 108. The regulator 108 may be a low dropout regulator (low dropout regulator, LDO). The regulator 108 is connected to each of the peripheral interface 104, the analog-to-digital converter 1052, and a drive power supply terminal VDD. The peripheral interface 104 may be further configured to configure a reference voltage of the analog-to-digital converter 1052 in response to a reference voltage configuration instruction sent by the main control circuit 40.

For example, the peripheral interface 104 may send, to the regulator 108, a target reference voltage carried in the reference voltage configuration instruction, and further, the regulator 108 may regulate a voltage of the drive power supply terminal VDD to the target reference voltage and provide the target reference voltage for the analog-to-digital converter 1052. The target reference voltage may be 2.5 V, 3.3 V, or 5 V.

Optionally, a sampling rate of the analog-to-digital converter 1052 may be greater than or equal to 300 kilohertz (kHz), a resolution may be 12 bits, and an error is ±5 least significant bits (least significant bit, LSB).

The main control circuit 40 configures a reference voltage of the analog-to-digital converter 1052 through the peripheral interface 104, to improve flexibility and reliability of the analog-to-digital converter 1052 during operation.

In this embodiment of this application, after the drive chip 100 is powered on, the fault detection circuit 103 may detect a fault. If detection succeeds (in other words, no fault is detected), a notification message indicating that detection succeeds may be sent to the main control circuit 40 through the peripheral interface 104. After receiving the notification message, the main control circuit 40 may configure the reference voltage of the analog-to-digital converter 1052 through the peripheral interface 104, and sets an enabling flag bit of the analog-to-digital converter 1052 (in other words, the analog-to-digital converter 1052 is enabled). Then, the analog-to-digital converter 1052 may start to operate, and a corresponding register may be refreshed in real time by using a latest voltage collection result, so that the main control circuit 40 can read the latest voltage collection result in real time.

In this embodiment of this application, as shown in FIG. 3, the shut off circuit 102 is further connected to the main control circuit 40 through the peripheral interface 104 of the drive chip 100. The first fault signal received by the shut off circuit 102 may further include the second fault sub-signal sent by the main control circuit 40. Correspondingly, the peripheral interface 104 is further configured to: receive the second fault sub-signal sent by the main control circuit 40, and send the second fault sub-signal to the shut off circuit 102.

That is, in this embodiment of this application, the shut off circuit 102 not only may control, in response to the first fault sub-signal sent by the fault detection circuit 103, the first switching transistor M12 to be cut off, but also may control, in response to the second fault sub-signal sent by the main control circuit 40, the first switching transistor M12 to be cut off. Therefore, reliability of cutting off the first switching transistor M12 in a fault scenario is effectively improved.

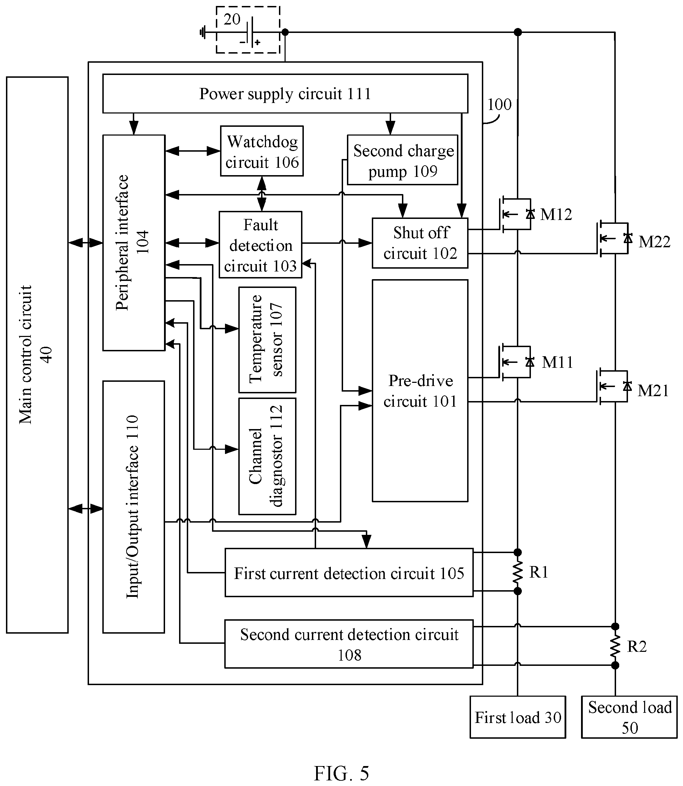

FIG. 5 is a schematic diagram of a structure of still another vehicle-mounted drive circuit according to an embodiment of this application. As shown in FIG. 5, the vehicle-mounted drive circuit may further include a second drive transistor M21, a second switching transistor M22, a second current detection circuit 108, and a second sampling resistor R2.

The second drive transistor M21, the second switching transistor M22, and the second sampling resistor R2 are connected in series, and the second drive transistor M21, the second switching transistor M22, and the second sampling resistor R2 are connected in series between this power supply 20 and a second load 50.

The pre-drive circuit 101 is further connected to a gate electrode of the second drive transistor M21, and the pre-drive circuit 101 is further configured to: control, in response to a second power-on instruction, the second drive transistor M21 to be conducted, and control, in response to a second power-off instruction, the second drive transistor M21 to be cut off.

The shut off circuit 102 is further connected to a gate electrode of the second switching transistor M22, and the shut off circuit 102 is further configured to: control, in response to the second power-on instruction, the second switching transistor M22 to be conducted, and control, in response to the second power-off instruction or a second fault signal, the second switching transistor M22 to be cut off.

In this embodiment of this application, both the second power-on instruction and the second power-off instruction may be sent by a main control circuit 40. For example, after detecting a power-on request for the second load 50, the main control circuit 40 may send the second power-on instruction to each of the pre-drive circuit 101 and the shut off circuit 102, to conduct the second drive transistor M21 and the second switching transistor M22. After detecting a power-off request for the second load 50, the main control circuit 40 may further send the second power-off instruction to each of the pre-drive circuit 101 and the shut off circuit 102, to cut off the second drive transistor M21 and the second switching transistor M22.

The second fault signal may be sent after the main control circuit 40 detects a fault, or may be sent after the fault detection circuit 103 detects a fault. After detecting a fault, the main control circuit 40 or the fault detection circuit 103 sends the second fault signal to the shut off circuit 102, to indicate the shut off circuit 102 to cut off the second switching transistor M22, so as to ensure that a second current channel between the power supply 20 and the second load 50 may be cut off in a timely manner, and avoid a case in which each element in the vehicle-mounted drive circuit 10 and the second load 50 are damaged when continuously operating in the fault scenario.

Two input terminals of the second current detection circuit 108 are bridged over two terminals of the second sampling resistor R2, a first output terminal of the second current detection circuit 108 is connected to the fault detection circuit 103, and the second current detection circuit 108 is configured to: collect a second voltage between the two terminals of the second sampling resistor R2, and send the collected second voltage to the fault detection circuit 103. The second voltage indicates a magnitude of a current in the second current channel between the power supply 20 and the second load 50.

The second fault signal is sent to the shut off circuit 102 if the fault detection circuit 103 detects any of the following cases:
The first interrupt instruction is received.

The second interrupt instruction is received.

That the second current channel is short-circuited or open-circuited is determined based on the second voltage.

The junction temperature is greater than the temperature threshold.

It can be learned from the foregoing descriptions that, when receiving the first interrupt instruction, receiving the second interrupt instruction, or detecting that the junction temperature of the drive chip is greater than the temperature threshold, the fault detection circuit 103 may send the first fault sub-signal and the second fault signal to the shut off circuit 102, to indicate the shut off circuit 102 to cut off both the first switching transistor M12 and the second switching transistor M22. However, if the fault detection circuit 103 detects that only the first current channel is short-circuited or open-circuited, the fault detection circuit 103 may send only the first fault sub-signal to the shut off circuit 102, to cut off the first switching transistor M12, and does not need to cut off the second switching transistor M22. In other words, the second switching transistor M22 may remain in a conducted state. Similarly, if the fault detection circuit 103 detects that only the second current channel is short-circuited or open-circuited, the fault detection circuit 103 may indicate the shut off circuit 102 to cut off only the second switching transistor M22, and the first switching transistor M12 may remain in a conducted state.

Compared with a case in which a discrete device is used to separately control a conducted/cutoff state of each current channel, in a case in which the drive chip in the vehicle-mounted drive circuit provided in this embodiment of this application may control a conducted/cutoff state of the two current channels, a degree of integration of the vehicle-mounted drive circuit is effectively improved, and a volume of the vehicle-mounted drive circuit is reduced.

Optionally, the vehicle-mounted drive circuit 10 may include a plurality of second drive transistors M21, a plurality of second switching transistors M22, a plurality of second current detection circuits 108, and a plurality of second sampling resistors R2. In other words, the vehicle-mounted drive circuit 10 may simultaneously drive a plurality of second loads 50.

Because the vehicle-mounted drive circuit 10 provided in this embodiment of this application can simultaneously drive a plurality of loads, the vehicle-mounted drive circuit may also be referred to as a multi-channel drive circuit, and the drive chip 100 in the vehicle-mounted drive circuit 10 may also be referred to as a multi-channel drive chip. Correspondingly, the pre-drive circuit 101 may be referred to as a multi-channel pre-drive circuit, and the shut off circuit 102 may be referred to as a multi-channel shut off circuit. For example, the vehicle-mounted drive circuit 10 can simultaneously drive eight loads. In other words, the drive chip 100 may be an 8-channel drive chip.

A multi-channel drive chip 100 provided in this embodiment of this application may communicate with the main control circuit 40 through one peripheral interface 104, to effectively reduce a quantity of interfaces that need to be disposed in the main control circuit 40, so as to effectively simplify a circuit structure of the main control circuit 40 and reduce costs of the main control circuit 40. In addition, one current detection circuit is configured for each current channel, to independently detect a current in each current channel, and further independently control a conducted/cutoff state of each current channel. Therefore, flexibility of controlling each current channel in a multi-channel scenario is effectively improved.

In this embodiment of this application, both a structure and an operating principle of the second current detection circuit 108 may be the same as those of the first current detection circuit 105. Details are not described herein again. In addition, for clear illustration in the figure, FIG. 5 shows only a part of a connection relationship of the second current detection circuit 108.

In the solution provided in this embodiment of this application, the current detection circuit is integrated into the drive chip 100, so that the vehicle-mounted drive circuit 10 can complete current collection by configuring only one sampling resistor for each current channel. This greatly simplifies a circuit design and reduces costs of the vehicle-mounted drive circuit.

Optionally, a resistance value of each sampling resistor used in the vehicle-mounted drive circuit 10 may be in a unit of milliohm. For example, the resistance value of the sampling resistor may range from 0.1 milliohms to 50 milliohms.

Optionally, the second switching transistor M22 is also an N-type transistor. The first drive transistor M11 and the second drive transistor M21 each are also an N-type transistor. For example, each transistor in the vehicle-mounted drive circuit 10 may be an N-channel enhanced metal-oxide-semiconductor field-effect transistor (metal-oxide-semiconductor field-effect transistor, MOSFET). Alternatively, in a high current scenario, a transistor in the vehicle-mounted drive circuit 10 may be an N-type insulated gate bipolar transistor (insulated gate bipolar transistor, IGBT).

Correspondingly, as shown in FIG. 3, the drive chip 100 further includes a second charge pump 109. The second charge pump 109 is connected to the pre-drive circuit 101, and is configured to provide a drive voltage for the pre-drive circuit 101.

Because the switching transistor and the drive transistor may be respectively driven by using two charge pumps, a case in which a pump pressure of a charge pump is faulty when the charge pump is shared can be avoided, to ensure drive reliability.

Referring to FIG. 3 and FIG. 5, the drive chip 100 may further include an input/output interface 110, a power supply circuit 111, and a channel diagnostor (channel diagnostics) 112.

The input/output interface 110 is connected to each of the main control circuit 40 and the pre-drive circuit 101, to implement communication between the main control circuit 40 and the pre-drive circuit 101. For example, the input/output interface 110 may be a general-purpose input/output (general-purpose input/output, GPIO) interface. In addition, the input/output interface 110 may be further connected to the shut off circuit 102. To be specific, the main control circuit 40 may further communicate with the shut off circuit 102 through the input/output interface 110, for example, send a fault signal to the shut off circuit 102 through the input/output interface 110.

The power supply circuit 111 is connected to each of the power supply 20 and another component in the drive chip 100, and is configured to supply power to each component in the drive chip 100.

The channel diagnostor 112 is connected to each of the peripheral interface 104, the pre-drive circuit 101, and the fault detection circuit 103. The main control circuit 40 may send, to the channel diagnostor 112 through the peripheral interface 104, an identifier of a current channel that needs to be conducted currently. The channel diagnostor 112 may further determine, based on the pre-drive circuit 101, whether an actually conducted current channel is the same as the circuit channel indicated by the identifier sent by the main control circuit 40. If the actually conducted current channel is different from the circuit channel indicated by the identifier sent by the main control circuit 40, the channel diagnostor 112 may send a channel fault indication to the fault detection circuit 103, to indicate the fault detection circuit 103 to cut off the wrongly conducted current channel.

In conclusion, this embodiment of this application provides a vehicle-mounted drive circuit. The vehicle-mounted drive circuit includes the drive chip, and the first drive transistor and the first switching transistor that are connected in series between the power supply and the first load. Because the shut off circuit in the drive chip can cut off the first switching transistor in response to the first fault signal, it may be ensured that the current channel between the power supply and the first load is cut off in a timely manner in the fault scenario, to avoid a case in which each element in the vehicle-mounted drive circuit and the first load are damaged when continuously operating in the fault scenario. Because the shut off circuit provides a redundant shut off path for the first current channel, reliability of the vehicle-mounted drive circuit during operation is effectively improved.

In addition, both the pre-drive circuit for controlling the current channel to be conducted or cut off and the shut off circuit for providing the redundant shut off path for the current channel are integrated into the drive chip, to avoid increasing a volume and costs of the vehicle-mounted drive circuit, and improve a degree of integration of the vehicle-mounted drive circuit. Further, because both the first drive transistor and the first switching transistor are disposed independently of the drive chip and are not integrated into the drive chip, a problem that the drive chip is overheated due to a large drive current does not need to be considered. In other words, the first drive transistor and the first switching transistor may provide a large drive current for the first load.

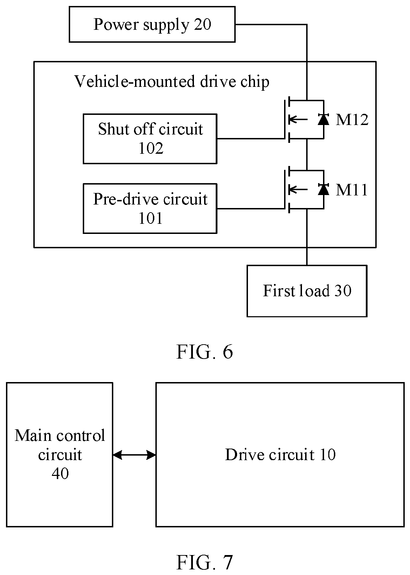

An embodiment of this application further provides a vehicle-mounted drive chip. As shown in FIG. 6, the vehicle-mounted drive chip includes a first drive transistor M11, a first switching transistor M12, a pre-drive circuit 101, and a shut off circuit 102.

The first drive transistor M11 and the first switching transistor M12 are connected in series, and the first drive transistor M11 and the first switching transistor M12 are connected in series between a power supply 20 and a first load 30.

The pre-drive circuit 101 is connected to a gate electrode of the first drive transistor M11, and the pre-drive circuit 101 controls, in response to a first power-on instruction, the first drive transistor M11 to be conducted, and controls, in response to a first power-off instruction, the first drive transistor M11 to be cut off.

The shut off circuit 102 is connected to a gate electrode of the first switching transistor M12, and the shut off circuit 102 controls, in response to the first power-on instruction, the first switching transistor M12 to be conducted, and controls, in response to the first power-off instruction or a first fault signal, the first switching transistor M12 to be cut off.

Compared with the vehicle-mounted drive circuit provided in the foregoing embodiment, the vehicle-mounted drive chip integrates both the first drive transistor M11 and the first switching transistor M12 into the chip, to further improve a degree of integration of the drive circuit and reduce a volume of the drive circuit. Certainly, the vehicle-mounted drive chip may be a multi-channel drive chip. In other words, one or more second drive transistors and one or more second switching transistors may be integrated into the vehicle-mounted drive chip.

For another element in the vehicle-mounted drive chip and a function of each element, refer to related descriptions in the embodiment of the vehicle-mounted drive circuit. Details are not described herein again.

An embodiment of this application further provides a vehicle-mounted drive part. As shown in FIG. 7, the vehicle-mounted drive part includes a drive circuit 10 and a main control circuit 40. The drive circuit 10 is a vehicle-mounted drive circuit provided in the foregoing embodiment, for example, may be the vehicle-mounted drive circuit shown in FIG. 1, FIG. 3, or FIG. 5. Alternatively, the drive circuit 10 is the vehicle-mounted drive chip provided in the foregoing embodiment, for example, may be the vehicle-mounted drive chip shown in FIG. 6.

Referring to FIG. 3 and FIG. 5, the main control circuit 40 is connected to the drive circuit 10, and is configured to: send a first power-on instruction to each of a pre-drive circuit 101 and a shut off circuit 102 in the drive circuit 10 in response to a power-on request for a first load 30, and send a first power-off instruction to each of the pre-drive circuit 101 and the shut off circuit 102 in response to a power-off request for the first load 30.

Optionally, the main control circuit 40 may be a micro control unit (micro controller unit, MCU), or may be referred to as a single-chip microcomputer.

In this embodiment of this application, the main control circuit 40 may be further configured to: detect whether the vehicle-mounted drive part is faulty, and send a second fault sub-signal to a peripheral interface 104 of the drive circuit 10 if detecting that the vehicle-mounted drive part is faulty. The second fault sub-signal is used to indicate the shut off circuit 102 in the drive circuit 10 to cut off a first switching transistor M12, in other words, to cut off a first current channel between a power supply 20 and the first load 30.

Optionally, the drive circuit 10 may be a multi-channel drive circuit. Correspondingly, if detecting that the vehicle-mounted part is faulty, the main control circuit 40 may alternatively send a second fault signal to the peripheral interface 104, to indicate the shut off circuit 102 to cut off a second switching transistor M22, in other words, to cut off a second current channel between the power supply 20 and a second load 50.

Optionally, the vehicle-mounted drive part provided in this embodiment of this application may include a voltage collection circuit connected to the main control circuit 40, and the voltage collection circuit is further configured to be connected to the power supply 20. The voltage collection circuit can collect a voltage of the power supply 20 and send the voltage to the main control circuit 40. The main control circuit 40 may detect, based on the voltage collected by the voltage collection circuit, whether the power supply 20 is undervoltage or overvoltage. If detecting that the power supply 20 is undervoltage or overvoltage, the main control circuit 40 may send a second fault sub-signal and the second fault signal to the peripheral interface 104.

Optionally, the vehicle-mounted drive part may be applied to the vehicle-mounted field, and may be applied to a scenario in which a high current (for example, 5 amperes to 60 amperes) is provided to supply power. For example, the vehicle-mounted drive part may be applied to a vehicle-mounted part such as a vehicle controller unit (vehicle controller unit, VCU), a vehicle interface unit (vehicle interface unit, VIU), a power distribution unit (power distribution unit, PDU), or a body controller module (body control module, BCM).

Certainly, the vehicle-mounted drive part may alternatively be applied to another field in which a low voltage (for example, below 24 V or below 40 V) needs to be used to supply power and output power. For example, the vehicle-mounted drive part may alternatively be applied to a headlamp or a power adapter of a vehicle.

In conclusion, this embodiment of this application provides a vehicle-mounted drive part. Because the drive chip in the vehicle-mounted drive part can cut off a first switching transistor in response to the first fault signal, it may be ensured that the current channel between the power supply and the first load is cut off in a timely manner in a fault scenario, to avoid a case in which each element in the vehicle-mounted drive part and the first load are damaged when continuously operating in the fault scenario.

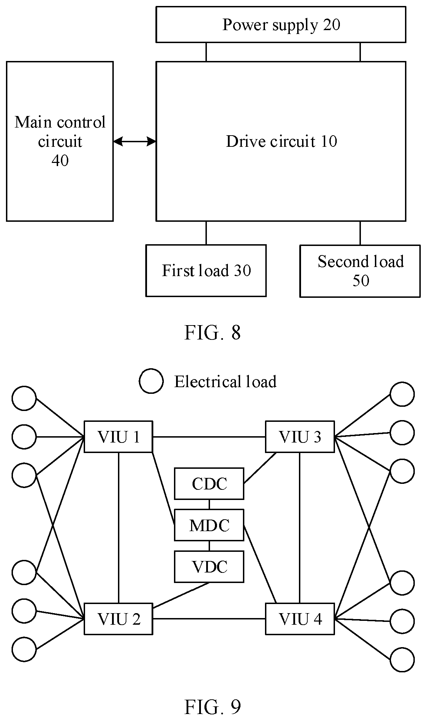

An embodiment of this application further provides an electronic device. As shown in FIG. 8, the electronic device includes a power supply 20, a first load 30, and the vehicle-mounted drive part provided in the embodiment. For example, the vehicle-mounted drive part may be shown in FIG. 7.

Referring to FIG. 1, FIG. 3, FIG. 5, and FIG. 6, a first drive transistor M11 and a first switching transistor M12 in the vehicle-mounted drive part are connected in series between a power supply 20 and a first load 30.

Optionally, a vehicle-mounted drive circuit 10 in the vehicle-mounted drive part may be a multi-channel drive circuit. Correspondingly, as shown in FIG. 8, the electronic device may further include one or more second loads 50, and FIG. 8 schematically shows only one second load 50. The vehicle-mounted drive circuit 10 may be further configured to control a conducted/cutoff state of a second current channel between the power supply 20 and each second load 50.

In this embodiment of this application, the electronic device may be a vehicle, for example, may be an electric vehicle. Correspondingly, a voltage of the power supply 20 may be 12 V or 24 V.

With the development of new four modernizations (electrification, intellectualization, networking, and sharing) of the vehicle, more loads are integrated into the vehicle, and a power supply requirement of the entire vehicle also changes. A change is that a power supply region is centralized, leading to an increasingly larger power supply current. Another change is that automated driving has a higher requirement for the vehicle-mounted drive circuit. For example, the circuit needs to be miniaturized, a current may be detected, and a redundant cutoff may be performed.

The vehicle provided in this embodiment of this application can meet the foregoing power supply requirements. As shown in FIG. 9, a power supply system of the vehicle provided in this embodiment of this application may include a plurality of VIUs. For example, the power supply system shown in FIG. 9 includes four VIUs: a VIU 1 to a VIU 4. Each VIU is integrated with the vehicle-mounted drive part provided in the foregoing embodiment, and each VIU can centrally supply power to a plurality of loads in one region of the vehicle. Therefore, the plurality of VIUs can implement distributed centralized power supply. Each VIU may further perform power supply management and drive control on the plurality of loads.

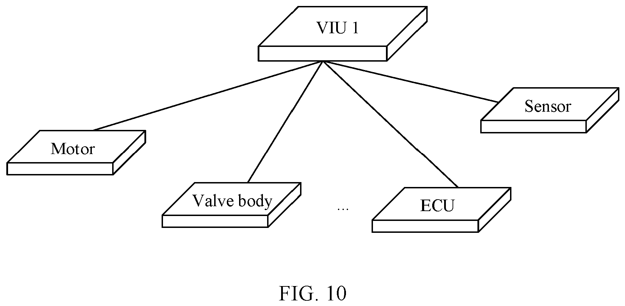

For example, referring to FIG. 10, the VIU 1 in the power supply system may centrally supply power to a motor, a valve body, an ECU, and a sensor in the vehicle.

Optionally, as shown in FIG. 9, the vehicle may further include a cockpit domain controller (cockpit domain controller, CDC), a vehicle dynamic control (vehicle dynamic control, VDC) system, and a mobile data center (mobile data center, MDC). The CDC, the VDC, and the MDC each are connected to one or more VIUs, and are configured to exchange information with the VIU.

In conclusion, this embodiment of this application provides an electronic device. Because the drive chip in the electronic device can cut off the switching transistor between the power supply and the load in response to a first fault signal, it may be ensured that a current channel between the power supply and the load is cut off in a timely manner in a fault scenario, to avoid a case in which each element in the vehicle-mounted drive part and the load are damaged when continuously operating in the fault scenario.

The foregoing descriptions are merely example embodiments of this application, and are not intended to limit this application.

## Claims

1. A vehicle-mounted drive circuit, wherein the vehicle-mounted drive circuit comprises a drive chip (100), a first drive transistor (M11), and a first switching transistor (M12), and the drive chip comprises a pre-drive circuit (101) and a shut off circuit (102);
the first drive transistor (M11) and the first switching transistor (M12) are connected in series, and the first drive transistor (M11) and the first switching transistor (M12) are configured to be connected in series between a power supply (20) and a first load (30);
the pre-drive circuit (101) is connected to a gate electrode of the first drive transistor (M11), and the pre-drive circuit (101) controls, in response to a first power-on instruction, the first drive transistor (M11) to be conducted, and controls, in response to a first power-off instruction, the first drive transistor (M11) to be cut off; and
the shut off circuit (102) is connected to a gate electrode of the first switching transistor (M12), and the shut off circuit (102) controls, in response to the first power-on instruction, the first switching transistor (M11) to be conducted, and controls, in response to the first power-off instruction or a first fault signal, the first switching transistor (M11) to be cut off;
the pre-drive circuit (101) is configured to control, in response to the first fault signal, the first drive transistor (M11) to be cut off; and
wherein when both the first drive transistor (M11) and the first switching transistor (M12) are controlled to be conducted, a first current channel between the power supply (20) and the first load (30) is conducted, and the power supply (20) can provide a drive current for the first load (30) by using the first drive transistor (M11) and the first switching transistor (M12), and when either of the first drive transistor (M11) and the first switching transistor (M12) is cut off, the first current channel between the power supply (20) and the first load (30) is cut off, and the power supply (20) cannot provide the drive current for the first load (30).

2. The vehicle-mounted drive circuit according to claim 1, wherein the shut off circuit comprises an interface sub-circuit and an execution sub-circuit, and the execution sub-circuit is connected to each of the interface sub-circuit and the gate electrode of the first switching transistor;
the interface sub-circuit provides a first switching signal for the execution sub-circuit in response to the first power-on instruction, and provides a second switching signal for the execution sub-circuit in response to the first power-off instruction or the first fault signal; and
the execution sub-circuit controls, in response to the first switching signal, the first switching transistor to be conducted, and controls, in response to the second switching signal, the first switching transistor to be cut off.

3. The vehicle-mounted drive circuit according to claim 2, wherein the first switching transistor is an N-type transistor, and the shut off circuit further comprises a first charge pump; and
the first charge pump is connected to each of a power supply terminal and the execution sub-circuit, and the first charge pump is configured to increase a voltage from the power supply terminal and provide the voltage for the execution sub-circuit.

4. The vehicle-mounted drive circuit according to any one of claims 1 to 3, wherein the first fault signal comprises a first fault sub-signal, and the drive chip further comprises a fault detection circuit connected to the shut off circuit; and
the fault detection circuit is configured to detect whether the vehicle-mounted drive circuit is faulty, and the fault detection circuit sends the first fault sub-signal to the shut off circuit if the fault detection circuit detects that the vehicle-mounted drive circuit is faulty.

5. The vehicle-mounted drive circuit according to claim 4, wherein the drive chip further comprises one or more of a peripheral interface, a first current detection circuit, a watchdog circuit, and a temperature sensor;
the peripheral interface is connected to a main control circuit, and the peripheral interface is configured to communicate with the main control circuit, and send a first interrupt instruction to the fault detection circuit if detecting that communication with the main control circuit is interrupted;
the watchdog circuit is connected to each of the peripheral interface and the fault detection circuit, and the watchdog circuit is configured to send a second interrupt instruction to the fault detection circuit if detecting that communication with the peripheral interface is interrupted;
the first current detection circuit is connected to the fault detection circuit, and the first current detection circuit is configured to detect a current in a first current channel between the power supply and the first load, and send, to the fault detection circuit, a first voltage for indicating a magnitude of the current in the first current channel;
the temperature sensor is configured to detect a junction temperature of the drive chip, and send the junction temperature to the fault detection circuit; and
it is determined that the vehicle-mounted drive circuit is faulty if the fault detection circuit detects any of the following cases:
the first interrupt instruction is received;
the second interrupt instruction is received;
it is determined, based on the first voltage, that the first current channel is short-circuited or open-circuited; and
the junction temperature is greater than a temperature threshold.

6. The vehicle-mounted drive circuit according to claim 5, wherein the drive chip comprises the first current detection circuit, and the vehicle-mounted drive circuit further comprises a first sampling resistor;
the first sampling resistor is connected in series to the first drive transistor and the first switching transistor; and
two input terminals of the first current detection circuit are bridged over two terminals of the first sampling resistor, a first output terminal of the first current detection circuit is connected to the fault detection circuit, and the first current detection circuit is configured to collect a first voltage between the two terminals of the first sampling resistor, and send the collected first voltage to the fault detection circuit.

7. The vehicle-mounted drive circuit according to claim 6, wherein a second output terminal of the first current detection circuit is connected to the peripheral interface; and
the first current detection circuit is further configured to perform analog-to-digital conversion on the collected voltage, to obtain a digital parameter of the voltage, and send the digital parameter to the main control circuit through the peripheral interface.

8. The vehicle-mounted drive circuit according to claim 7, wherein the first current detection circuit comprises a first filter, a second filter, a differential amplifier, and an analog-to-digital converter;
an input terminal of the first filter is connected to one terminal of the first sampling resistor, and an output terminal of the first filter is connected to a first input terminal of the differential amplifier;
an input terminal of the second filter is connected to the other terminal of the first sampling resistor, and an output terminal of the second filter is connected to a second input terminal of the differential amplifier; and
an output terminal of the differential amplifier is connected to each of the fault detection circuit and an input terminal of the analog-to-digital converter, and an output terminal of the analog-to-digital converter is connected to the peripheral interface.

9. The vehicle-mounted drive circuit according to claim 8, wherein a control terminal of the differential amplifier is further connected to the peripheral interface; and
the peripheral interface is further configured to configure a gain of the differential amplifier in response to a gain configuration instruction sent by the main control circuit.

10. The vehicle-mounted drive circuit according to any one of claims 5 to 9, wherein the vehicle-mounted drive circuit further comprises a second drive transistor, a second switching transistor, a second current detection circuit, and a second sampling resistor;
the second drive transistor, the second switching transistor, and the second sampling resistor are connected in series, and the second drive transistor, the second switching transistor, and the second sampling resistor are connected in series between the power supply and a second load;
the pre-drive circuit is further connected to a gate electrode of the second drive transistor, and the pre-drive circuit is further configured to control, in response to a second power-on instruction, the second drive transistor to be conducted, and control, in response to a second power-off instruction, the second drive transistor to be cut off;
the shut off circuit is further connected to a gate electrode of the second switching transistor, and the shut off circuit is further configured to control, in response to the second power-on instruction, the second switching transistor to be conducted, and control, in response to the second power-off instruction or a second fault signal, the second switching transistor to be cut off;
two input terminals of the second current detection circuit are bridged over two terminals of the second sampling resistor, a first output terminal of the second current detection circuit is connected to the fault detection circuit, the second current detection circuit is configured to collect a second voltage between the two terminals of the second sampling resistor, and send the collected second voltage to the fault detection circuit, and the second voltage indicates a magnitude of a current in a second current channel between the power supply and the second load; and
the second fault signal is sent to the shut off circuit if the fault detection circuit detects any of the following cases:
the first interrupt instruction is received;
the second interrupt instruction is received;
it is determined, based on the second voltage, that the second current channel is short-circuited or open-circuited;
and
the junction temperature is greater than a temperature threshold.

11. The vehicle-mounted drive circuit according to any one of claims 1 to 10, wherein the first fault signal comprises a second fault sub-signal, and the shut off circuit is further connected to the main control circuit through the peripheral interface of the drive chip; and
the peripheral interface is configured to receive the second fault sub-signal sent by the main control circuit, and send, to the shut off circuit, the second fault sub-signal sent by the main control circuit.

12. A vehicle-mounted drive part, wherein the vehicle-mounted drive part comprises a main control circuit and a drive circuit, and the drive circuit is the vehicle-mounted drive circuit according to any one of claims 1 to 11; and
the main control circuit is connected to the drive circuit, and is configured to send a first power-on instruction to the drive circuit in response to a power-on request for a first load, and send a first power-off instruction to the drive circuit in response to a power-off request for the first load.

13. The vehicle-mounted drive part according to claim 12, wherein the main control circuit is further configured to:
detect whether the vehicle-mounted drive part is faulty, and send a second fault sub-signal to the drive circuit if detecting that the vehicle-mounted drive part is faulty.

## Patentansprüche

1. Fahrzeugmontierte Ansteuerschaltung, wobei die fahrzeugmontierte Ansteuerschaltung einen Ansteuerchip (100), einen ersten Ansteuertransistor (M11) und einen ersten Schalttransistor (M12) umfasst und der Ansteuerchip eine Voransteuerschaltung (101) und eine Abschaltschaltung (102) umfasst;
der erste Ansteuertransistor (M11) und der erste Schalttransistor (M12) in Reihe geschaltet sind und der erste Ansteuertransistor (M11) und der erste Schalttransistor (M12) dazu konfiguriert sind, zwischen einer Leistungsversorgung (20) und einer ersten Last (30) in Reihe geschaltet zu werden;
die Voransteuerschaltung (101) mit einer Gateelektrode des ersten Ansteuertransistors (M11) verbunden ist und die Voransteuerschaltung (101) den ersten Ansteuertransistor (M11) als Reaktion auf eine erste Einschaltanweisung so steuert, dass er leitend ist, und den ersten Ansteuertransistor (M11) als Reaktion auf eine erste Ausschaltanweisung so steuert, dass er gesperrt ist, und
die Abschaltschaltung (102) mit einer Gateelektrode des ersten Schalttransistors (M12) verbunden ist und die Abschaltschaltung (102) den ersten Schalttransistor (M11) als Reaktion auf die erste Einschaltanweisung so steuert, dass er leitend ist, und den ersten Schalttransistor (M11) als Reaktion auf die erste Ausschaltanweisung oder ein erstes Fehlersignal so steuert, dass er gesperrt ist,
die Voransteuerschaltung (101) dazu konfiguriert ist, den ersten Ansteuertransistor (M11) als Reaktion auf das erste Fehlersignal so zu steuern, dass er gesperrt ist; und
wobei, wenn sowohl der erste Ansteuertransistor (M11) als auch der erste Schalttransistor (M12) so gesteuert werden, dass sie leitend sind, ein erster Stromkanal zwischen der Leistungsversorgung (20) und der ersten Last (30) leitend ist und die Leistungsversorgung (20) durch Verwenden des ersten Ansteuertransistors (M11) und des ersten Schalttransistors (M12) einen Ansteuerstrom für die erste Last (30) bereitstellen kann und, wenn einer von dem ersten Ansteuertransistor (M11) und dem ersten Schalttransistor (M12) gesperrt ist, der erste Stromkanal zwischen der Leistungsversorgung (20) und der ersten Last (30) gesperrt ist und die Leistungsversorgung (20) den Ansteuerstrom nicht für die erste Last (30) bereitstellen kann.

2. Fahrzeugmontierte Ansteuerschaltung nach Anspruch 1, wobei die Abschaltschaltung eine Schnittstellen-Teilschaltung und eine Ausführungs-Teilschaltung umfasst und die Ausführungs-Teilschaltung mit jeder von der Schnittstellen-Teilschaltung und der Gateelektrode des ersten Schalttransistors verbunden ist;
die Schnittstellen-Teilschaltung als Reaktion auf die erste Einschaltanweisung ein erstes Schaltsignal für die Ausführungs-Teilschaltung bereitstellt und als Reaktion auf die erste Ausschaltanweisung oder das erste Fehlersignal ein zweites Schaltsignal für die Ausführungs-Teilschaltung bereitstellt; und
die Ausführungs-Teilschaltung als Reaktion auf das erste Schaltsignal den ersten Schalttransistor so steuert, dass er leitend ist, und als Reaktion auf das zweite Schaltsignal den ersten Schalttransistor so steuert, dass er gesperrt ist.

3. Fahrzeugmontierte Ansteuerschaltung nach Anspruch 2, wobei der erste Schalttransistor ein n-Typ-Transistor ist und die Abschaltschaltung ferner eine erste Ladepumpe umfasst; und
die erste Ladepumpe mit jedem von einem Leistungsversorgungsanschluss und der Ausführungs-Teilschaltung verbunden ist und die erste Ladepumpe dazu konfiguriert ist, eine Spannung von dem Leistungsversorgungsanschluss zu erhöhen und die Spannung für die Ausführungs-Teilschaltung bereitzustellen.

4. Fahrzeugmontierte Ansteuerschaltung nach einem der Ansprüche 1 bis 3, wobei das erste Fehlersignal ein erstes Fehler-Teilsignal umfasst und der Ansteuerchip ferner eine Fehlerdetektionsschaltung umfasst, die mit der Abschaltschaltung verbunden ist; und
die Fehlerdetektionsschaltung dazu konfiguriert ist, zu detektieren, ob die fahrzeugmontierte Ansteuerschaltung fehlerhaft ist, und die Fehlerdetektionsschaltung das erste Fehler-Teilsignal an die Abschaltschaltung sendet, falls die Fehlerdetektionsschaltung detektiert, dass die fahrzeugmontierte Ansteuerschaltung fehlerhaft ist.

5. Fahrzeugmontierte Ansteuerschaltung nach Anspruch 4, wobei der Ansteuerchip ferner eines oder mehrere von einer Peripherieschnittstelle, einer ersten Stromdetektionsschaltung, einer Überwachungsschaltung und einem Temperatursensor umfasst;
die Peripherieschnittstelle mit einer Hauptsteuerschaltung verbunden ist und die Peripherieschnittstelle dazu konfiguriert ist, mit der Hauptsteuerschaltung zu kommunizieren und eine erste Unterbrechungsanweisung an die Fehlerdetektionsschaltung zu senden, falls detektiert wird, dass die Kommunikation mit der Hauptsteuerschaltung unterbrochen ist;
die Überwachungsschaltung mit jeder von der Peripherieschaltung und der Fehlerdetektionsschaltung verbunden ist und die Überwachungsschaltung dazu konfiguriert ist, eine zweite Unterbrechungsanweisung an die Fehlerdetektionsschaltung zu senden, falls detektiert wird, dass die Kommunikation mit der Peripherieschnittstelle unterbrochen ist;
die erste Stromdetektionsschaltung mit der Fehlerdetektionsschaltung verbunden ist und die erste Stromdetektionsschaltung dazu konfiguriert ist, einen Strom in einem ersten Stromkanal zwischen der Leistungsversorgung und der ersten Last zu detektieren und eine erste Spannung an die Fehlerdetektionsschaltung zu senden, um eine Größe des Stroms in dem ersten Stromkanal anzugeben;
der Temperatursensor dazu konfiguriert ist, eine Sperrschichttemperatur des Ansteuerchips zu detektieren und die Sperrschichttemperatur an die Fehlerdetektionsschaltung zu senden; und
bestimmt wird, dass die fahrzeugmontierte Ansteuerschaltung fehlerhaft ist, falls die Fehlerdetektionsschaltung einen der folgenden Fälle detektiert:
die erste Unterbrechungsanweisung wird empfangen;
die zweite Unterbrechungsanweisung wird empfangen;
basierend auf der ersten Spannung wird bestimmt, dass der erste Stromkanal kurzgeschlossen oder unterbrochen ist; und
die Sperrschichttemperatur liegt über einem Temperaturschwellenwert.

6. Fahrzeugmontierte Ansteuerschaltung nach Anspruch 5, wobei der Ansteuerchip die erste Stromdetektionsschaltung umfasst und die fahrzeugmontierte Ansteuerschaltung einen ersten Abtastwiderstand umfasst;
der erste Abtastwiderstand mit dem ersten Ansteuertransistor und dem ersten Schalttransistor in Reihe geschaltet ist; und
zwei Eingangsanschlüsse der ersten Stromdetektionsschaltung zwei Anschlüsse des ersten Abtastwiderstands überbrücken, ein erster Ausgangsanschluss der ersten Stromdetektionsschaltung mit der Fehlerdetektionsschaltung verbunden ist und die erste Stromdetektionsschaltung dazu konfiguriert ist, eine erste Spannung zwischen den beiden Anschlüssen des ersten Abtastwiderstands zu erfassen und die erfasste erste Spannung an die Fehlerdetektionsschaltung zu senden.

7. Fahrzeugmontierte Ansteuerschaltung nach Anspruch 6, wobei ein zweiter Ausgangsanschluss der ersten Stromdetektionsschaltung mit der Peripherieschnittstelle verbunden ist; und
die erste Stromdetektionsschaltung ferner dazu konfiguriert ist, Analog-Digital-Umwandlung an der erfassten Spannung durchzuführen, um einen digitalen Parameter der Spannung zu erhalten, und den digitalen Parameter über die Peripherieschnittstelle an die Hauptsteuerschaltung zu senden.

8. Fahrzeugmontierte Ansteuerschaltung nach Anspruch 7, wobei die erste Stromdetektionsschaltung ein erstes Filter, ein zweites Filter, einen Differenzverstärker und einen Analog-Digital-Wandler umfasst;
ein Eingangsanschluss des ersten Filters mit einem Anschluss des ersten Abtastwiderstands verbunden ist und ein Ausgangsanschluss des ersten Filters mit einem ersten Eingangsanschluss des Differenzverstärkers verbunden ist;
ein Eingangsanschluss des zweiten Filters mit dem anderen Anschluss des ersten Abtastwiderstands verbunden ist und ein Ausgangsanschluss des zweiten Filters mit einem zweiten Eingangsanschluss des Differenzverstärkers verbunden ist; und
ein Ausgangsanschluss des Differenzverstärkers mit jedem von der Fehlerdetektionsschaltung und einem Eingangsanschluss des Analog-Digital-Wandlers verbunden ist und ein Ausgangsanschluss des Analog-Digital-Wandlers mit der Peripherieschnittstelle verbunden ist.

9. Fahrzeugmontierte Ansteuerschaltung nach Anspruch 8, wobei ein Steueranschluss des Differenzverstärkers ferner mit der Peripherieschnittstelle verbunden ist; und
die Peripherieschnittstelle ferner dazu konfiguriert ist, eine Verstärkung des Differenzverstärkers als Reaktion auf eine von der Hauptsteuerschaltung gesendete Verstärkungskonfigurationsanweisung zu konfigurieren.

10. Fahrzeugmontierte Ansteuerschaltung nach einem der Ansprüche 5 bis 9, wobei die fahrzeugmontierte Ansteuerschaltung ferner einen zweiten Ansteuertransistor, einen zweiten Schalttransistor, eine zweite Stromdetektionsschaltung und einen zweiten Abtastwiderstand umfasst;
der zweite Ansteuertransistor, der zweite Schalttransistor und der zweite Abtastwiderstand in Reihe geschaltet sind und der zweite Ansteuertransistor, der zweite Schalttransistor und der zweite Abtastwiderstand zwischen der Leistungsversorgung und einer zweiten Last in Reihe geschaltet sind;
die Voransteuerschaltung ferner mit einer Gateelektrode des zweiten Ansteuertransistors verbunden ist und die Voransteuerschaltung ferner dazu konfiguriert ist, den zweiten Ansteuertransistor als Reaktion auf eine zweite Einschaltanweisung so zu steuern, dass er leitend ist, und den zweiten Ansteuertransistor als Reaktion auf eine zweite Ausschaltanweisung so zu steuern, dass er gesperrt ist;
die Abschaltschaltung ferner mit einer Gateelektrode des zweiten Schalttransistors verbunden ist und die Abschaltschaltung ferner dazu konfiguriert ist, den zweiten Schalttransistor als Reaktion auf die zweite Einschaltanweisung so zu steuern, dass er leitend ist, und den zweiten Schalttransistor als Reaktion auf die zweite Ausschaltanweisung so zu steuern, dass er gesperrt ist;
zwei Eingangsanschlüsse der zweiten Stromdetektionsschaltung zwei Anschlüsse des ersten Abtastwiderstands überbrücken, ein erster Ausgangsanschluss der zweiten Stromdetektionsschaltung mit der Fehlerdetektionsschaltung verbunden ist, die zweite Stromdetektionsschaltung dazu konfiguriert ist, eine zweite Spannung zwischen den beiden Anschlüssen des zweiten Abtastwiderstands zu erfassen und die erfasste zweite Spannung an die Fehlerdetektionsschaltung zu senden, und die zweite Spannung eine Größe eines Stroms in einem zweiten Stromkanal zwischen der Leistungsversorgung und der zweiten Last angibt; und
das zweite Fehlersignal an die Abschaltschaltung gesendet wird, falls die Fehlerdetektionsschaltung einen der folgenden Fälle detektiert:
die erste Unterbrechungsanweisung wird empfangen;
die zweite Unterbrechungsanweisung wird empfangen;
basierend auf der zweiten Spannung wird bestimmt, dass der zweite Stromkanal kurzgeschlossen oder unterbrochen ist; und
die Sperrschichttemperatur liegt über einem Temperaturschwellenwert.

11. Fahrzeugmontierte Ansteuerschaltung nach einem der Ansprüche 1 bis 10, wobei das erste Fehlersignal ein zweites Fehler-Teilsignal umfasst und die Abschaltschaltung ferner über die Peripherieschnittstelle des Ansteuerchips mit der Hauptsteuerschaltung verbunden ist; und
die Peripherieschnittstelle dazu konfiguriert ist, das von der Hauptsteuerschaltung gesendete zweite Fehler-Teilsignal zu empfangen und das von der Hauptsteuerschaltung gesendete zweite Fehler-Teilsignal an die Abschaltschaltung zu senden.

12. Fahrzeugmontiertes Ansteuerteil, wobei das fahrzeugmontierte Ansteuerteil eine Hauptsteuerschaltung und eine Ansteuerschaltung umfasst und die Ansteuerschaltung die fahrzeugmontierte Ansteuerschaltung nach einem der Ansprüche 1 bis 11 ist; und
die Hauptsteuerschaltung mit der Ansteuerschaltung verbunden und dazu konfiguriert ist, als Reaktion auf eine Einschaltanforderung für eine erste Last eine erste Einschaltanweisung an die Ansteuerschaltung zu senden und als Reaktion auf eine Ausschaltanforderung für die erste Last eine erste Ausschaltanweisung an die Ansteuerschaltung zu senden.

13. Fahrzeugmontiertes Ansteuerteil nach Anspruch 12, wobei die Hauptsteuerschaltung ferner zu Folgendem konfiguriert ist:
Detektieren, ob das fahrzeugmontierte Ansteuerteil fehlerhaft ist und Senden eines zweiten Fehler-Teilsignals an die Ansteuerschaltung, falls detektiert wird, dass das fahrzeugmontierte Ansteuerteil fehlerhaft ist.

## Revendications

1. Circuit d'attaque monté sur véhicule, ce circuit d'attaque monté sur véhicule comprenant une puce d'attaque (100), un premier transistor d'attaque (M11), et un premier transistor de commutation (M12), et la puce d'attaque comprenant un circuit de pré-attaque (101) et un circuit d'arrêt (102) ;
le premier transistor d'attaque (M11) et le premier transistor de commutation (M12) étant connectés en série, et le premier transistor d'attaque (M11) et le premier transistor de commutation (M12) étant configurés de façon à être connectés en série entre une alimentation électrique (20) et une première charge (30) ;
le circuit de pré-attaque (101) étant connecté à une électrode de grille du premier transistor d'attaque (M11), et le circuit de pré-attaque (101) commandant, en réponse à une première instruction de mise sous tension, la mise dans l'état passant du premier transistor d'attaque (M11), et commandant, en réponse à une première instruction de mise hors tension, la mise dans l'état bloqué du premier transistor d'attaque (M11) ; et le circuit d'arrêt (102) étant connecté à une électrode de grille du premier transistor de commutation (M12), et le circuit d'arrêt (102) commandant, en réponse à la première instruction de mise sous tension, la mise dans l'état passant du premier transistor de commutation (M11), et commandant, en réponse à la première instruction de mise hors tension ou à un premier signal de défaut, la mise dans l'état bloqué du premier transistor de commutation (M11) ;
le circuit de pré-attaque (101) étant configuré de façon à commander, en réponse au premier signal de défaut, la mise dans l'état bloqué du premier transistor d'attaque (M11) ; et
lorsque le premier transistor d'attaque (M11) et le premier transistor de commutation (M12) sont commandés tous les deux pour être mis dans l'état passant, un premier canal de courant entre l'alimentation électrique (20) et la première charge (30) étant dans l'état passant, et l'alimentation électrique (20) pouvant fournir un courant d'attaque pour la première charge (30) en utilisant le premier transistor d'attaque (M11) et le premier transistor de commutation (M12), et lorsque soit le premier transistor d'attaque (M11), soit le premier transistor de commutation (M12) est dans l'état bloqué, le premier canal de courant entre l'alimentation électrique (20) et la première charge (30) étant dans l'état bloqué, et l'alimentation électrique (20) ne pouvant pas fournir le courant d'attaque pour la première charge (30).

2. Circuit d'attaque monté sur véhicule selon la revendication 1, dans lequel le circuit d'arrêt comprend un sous-circuit d'interface et un sous-circuit d'exécution, et dans lequel ce sous-circuit d'exécution est connecté à la fois au sous-circuit d'interface et à l'électrode de grille du premier transistor de commutation ;
le sous-circuit d'interface fournissant un premier signal de commutation pour le sous-circuit d'exécution en réponse à la première instruction de mise sous tension, et fournissant un deuxième signal de commutation pour le sous-circuit d'exécution en réponse à la première instruction de mise hors tension ou au premier signal de défaut ; et
le sous-circuit d'exécution commandant, en réponse au premier signal de commutation, la mise dans l'état passant du premier transistor de commutation, et commandant, en réponse au deuxième signal de commutation, la mise dans l'état bloqué du premier transistor de commutation.

3. Circuit d'attaque monté sur véhicule selon la revendication 2, dans lequel le premier transistor de commutation est un transistor de type N, et le circuit d'arrêt comprend en outre une première pompe de charge ; et dans lequel
cette première pompe de charge est connectée à une borne d'alimentation électrique et au sous-circuit d'exécution, et cette première pompe de charge est configurée de façon à augmenter une tension venant de la borne de l'alimentation électrique et à fournir la tension pour le sous-circuit d'exécution.

4. Circuit d'attaque monté sur véhicule selon l'une quelconque des revendications 1 à 3, dans lequel le premier signal de défaut comprend un premier sous-signal de défaut, et la puce d'attaque comprend en outre un circuit de détection de défaut connecté au circuit d'arrêt ; et dans lequel
le circuit de détection de défaut est configuré de façon à détecter si le circuit d'attaque monté sur véhicule est défectueux ou pas, et le circuit de détection de défaut envoie le premier sous-signal de défaut au circuit d'arrêt si le circuit de détection de défaut détecte que le circuit d'attaque monté sur véhicule est défectueux.

5. Circuit d'attaque monté sur véhicule selon la revendication 4, dans lequel la puce d'attaque comprend en outre un ou plusieurs des éléments suivants : une interface périphérique, un premier circuit de détection de courant, un circuit de chien de garde, et un capteur de température ;
l'interface périphérique étant connectée à un circuit de commande principal, et l'interface périphérique étant configurée de façon à communiquer avec le circuit de commande principal, et à envoyer une première instruction d'interruption au circuit de détection de défaut s'il détecte que la communication avec le circuit de commande principal est interrompue ;
le circuit de chien de garde étant connecté à l'interface périphérique et au circuit de détection de défaut, et le circuit de chien de garde étant configuré de façon à envoyer une deuxième instruction d'interruption au circuit de détection de défaut s'il détecte que la communication avec l'interface périphérique est interrompue ;
le premier circuit de détection de courant étant connecté au circuit de détection de défaut, et le premier circuit de détection de courant étant configuré de façon à détecter un courant dans un premier canal de courant entre l'alimentation électrique et la première charge, et à envoyer, au circuit de détection de défaut, une première tension pour indiquer une grandeur du courant dans le premier canal de courant ;
le capteur de température étant configuré de façon à détecter une température de jonction de la puce d'attaque, et à envoyer la température de jonction au circuit de détection de défaut ; et
il est déterminé que le circuit d'attaque monté sur véhicule est défectueux si le circuit de détection de défaut détecte un quelconque des cas suivants :
la première instruction d'interruption est reçue ;
la deuxième instruction d'interruption est reçue ;
il est déterminé, en se basant sur la première tension, que le premier canal de courant est en court-circuit ou en circuit ouvert ; et
la température de jonction est plus grande qu'un seuil de température.

6. Circuit d'attaque monté sur véhicule selon la revendication 5, dans lequel la puce d'attaque comprend le premier circuit de détection de courant, et ce circuit d'attaque monté sur véhicule comprenant en outre une première résistance d'échantillonnage ;
cette première résistance d'échantillonnage étant connectée en série au premier transistor d'attaque et au premier transistor de commutation ; et
deux bornes d'entrée du premier circuit de détection de courant étant pontées au-dessus de deux bornes de la première résistance d'échantillonnage, une première borne de sortie du premier circuit de détection de courant étant connectée au circuit de détection de défaut, et le premier circuit de détection de courant étant configuré de façon à recueillir une première tension entre les deux bornes de la première résistance d'échantillonnage, et à envoyer cette première tension recueillie au circuit de détection de défaut.

7. Circuit d'attaque monté sur véhicule selon la revendication 6, dans lequel une deuxième borne de sortie du premier circuit de détection de courant est connectée à l'interface périphérique ; et dans lequel
le premier circuit de détection de courant est configuré en outre de façon à exécuter une conversion analogique-numérique sur la tension recueillie, afin d'obtenir un paramètre numérique de la tension, et à envoyer ce paramètre numérique au circuit de commande principal via l'interface périphérique.

8. Circuit d'attaque monté sur véhicule selon la revendication 7, dans lequel le premier circuit de détection de courant comprend un premier filtre, un deuxième filtre, un amplificateur différentiel, et un convertisseur analogique-numérique ;
une borne d'entrée du premier filtre étant connectée à une borne de la première résistance d'échantillonnage, et une borne de sortie du premier filtre étant connectée à une première borne d'entrée de l'amplificateur différentiel ;
une borne d'entrée du deuxième filtre étant connectée à l'autre borne de la première résistance d'échantillonnage, et une borne de sortie du deuxième filtre étant connectée à une deuxième borne d'entrée de l'amplificateur différentiel ; et
une borne de sortie de l'amplificateur différentiel étant connectée à la fois au circuit de détection de défaut et à une borne d'entrée du convertisseur analogique-numérique, et une borne de sortie du convertisseur analogique-numérique étant connectée à l'interface périphérique.

9. Circuit d'attaque monté sur véhicule selon la revendication 8, dans lequel une borne de commande de l'amplificateur différentiel est connectée en outre à l'interface périphérique ; et dans lequel
l'interface périphérique est configurée en outre de façon à configurer un gain de l'amplificateur différentiel en réponse à une instruction de configuration de gain envoyée par le circuit de commande principal.

10. Circuit d'attaque monté sur véhicule selon l'une quelconque des revendications 5 à 9, ce circuit d'attaque monté sur véhicule comprenant un deuxième transistor d'attaque, un deuxième transistor de commutation, un deuxième circuit de détection de courant et une deuxième résistance d'échantillonnage ;
le deuxième transistor d'attaque, le deuxième transistor de commutation et la deuxième résistance d'échantillonnage étant connectés en série, et le deuxième transistor d'attaque, le deuxième transistor de commutation et la deuxième résistance d'échantillonnage étant connectés en série entre l'alimentation électrique et une deuxième charge ;
le circuit de pré-attaque étant connecté en outre à une électrode de grille du deuxième transistor d'attaque, et le circuit de pré-attaque étant configuré en outre de façon à commander, en réponse à une deuxième instruction de mise sous tension, la mise dans l'état passant du deuxième transistor d'attaque, et à commander, en réponse à une deuxième instruction de mise hors tension, la mise dans l'état de blocage du deuxième transistor d'attaque ;
le circuit d'arrêt étant connecté en outre à une électrode de grille du deuxième transistor de commutation, et le circuit d'arrêt étant configuré en outre de façon à commander, en réponse à la deuxième instruction de mise sous tension, la mise dans l'état passant du deuxième transistor de commutation, et à commander, en réponse à la deuxième instruction de mise hors tension ou à un deuxième signal de défaut, la mise dans l'état de blocage du deuxième transistor de commutation ;
deux bornes d'entrée du deuxième circuit de détection de courant étant pontées au-dessus de deux bornes de la deuxième résistance d'échantillonnage, une première borne de sortie du deuxième circuit de détection de courant étant connectée au circuit de détection de défaut, le deuxième circuit de détection de courant étant configuré de façon à recueillir une deuxième tension entre les deux bornes de la deuxième résistance d'échantillonnage, et à envoyer cette deuxième tension recueillie au circuit de détection de défaut, et cette deuxième tension indiquant une grandeur d'un courant dans un deuxième canal de courant entre l'alimentation électrique et la deuxième charge ; et
le deuxième signal de défaut étant envoyé au circuit d'arrêt si le circuit de détection de défaut détecte un des cas suivants :
la première instruction d'interruption est reçue ;
la deuxième instruction d'interruption est reçue ;
il est déterminé, en se basant sur la deuxième tension, que le deuxième canal de courant est en court-circuit ou en circuit ouvert ; et
la température de jonction est plus grande qu'un seuil de température.

11. Circuit d'attaque monté sur véhicule selon l'une quelconque des revendications 1 à 10, dans lequel le premier signal de défaut comprend un deuxième sous-signal de défaut, et le circuit d'arrêt est connecté en outre au circuit de commande principal via l'interface périphérique de la puce d'attaque ; et dans lequel
l'interface périphérique est configurée de façon à recevoir le deuxième sous-signal de défaut envoyé par le circuit de commande principal, et à envoyer, au circuit d'arrêt, le deuxième sous-signal de défaut envoyé par le circuit de commande principal.

12. Étage d'attaque monté sur véhicule, cet étage d'attaque monté sur véhicule comprenant un circuit de commande principal et un circuit d'attaque, et ce circuit d'attaque étant le circuit d'attaque monté sur véhicule selon l'une quelconque des revendications 1 à 11 ; et dans lequel
le circuit de commande principal est connecté au circuit d'attaque, et est configuré de façon à envoyer une première instruction de mise sous tension au circuit d'attaque en réponse à une demande de mise sous tension pour une première charge, et à envoyer une première instruction de mise hors tension au circuit d'attaque en réponse à une demande de mise hors tension pour la première charge.

13. Étage d'attaque monté sur véhicule selon la revendication 12, dans lequel le circuit de commande principal est configuré en outre de façon à :
détecter si l'étage d'attaque monté sur véhicule est défectueux ou pas, et envoyer un deuxième sous-signal de défaut au circuit d'attaque s'il détecte que l'étage d'attaque monté sur véhicule est défectueux.
